# EUROPÄISCHE PATENTSCHRIFT

(11) **EP 4 334 241 B1**
(45) Veröffentlichungstag und Bekanntmachung des Hinweises auf die Patenterteilung: **04.09.2024**
(21) Anmeldenummer: 23739214.7
(22) Anmeldetag: 05.07.2023
(51) Int. Cl.: B81C 1/00, B23K 26/53, H04R 19/00, C03C 15/00, C03C 23/00

(54) **MIKROMECHANISCHE KAMMSTRUKTUR AUS GLAS SOWIE ZUGEHÖRIGES VERFAHREN UND VERWENDUNG**
MICROMECHANICAL COMB STRUCTURE MADE OF GLASS, AND ASSOCIATED METHOD AND USE
STRUCTURE EN PEIGNE MICROMÉCANIQUE EN VERRE, ET PROCÉDÉ ET UTILISATION ASSOCIÉS

(30) Priorität: 05.07.2022 DE 102022116784
(43) Veröffentlichungstag der Anmeldung: 13.03.2024
(73) Patentinhaber: LPKF Laser & Electronics SE, 30827 Garbsen (DE)
(72) Erfinder: OSTHOLT, Roman, 30855 Langenhagen (DE); AMBROSIUS, Norbert, 30827 Garbsen (DE); BERTKE, Maik, 30161 Hannover (DE); SCHUDAK, Svenja, 30449 Hannover (DE); LOOTZE, Michael, 30827 Garbsen (DE); SZIEDAT, Julia, 31675 Bückeburg (DE)
(74) Vertreter: Mertzlufft-Paufler, Cornelius
(86) Internationale Anmeldenummer: PCT/EP2023/068494
(87) Internationale Veröffentlichungsnummer: WO 2024/008774

(56) Entgegenhaltungen:
- US-A1- 2022 184 744
- SANTOS RAFAEL ET AL: "Bringing New Life To Glass For Wafer-Level Packaging Applications", 2020 INTERNATIONAL WAFER LEVEL PACKAGING CONFERENCE (IWLPC), SMTA, 13 October 2020 (2020-10-13), pages 1 - 7, XP033888879, DOI: 10.23919/IWLPC52010.2020.9375851
- SANGWOO LEE ET AL: "The Surface/Bulk Micromachining (SBM) Process: A New Method for Fabricating Released MEMS in Single Crystal Silicon", JOURNAL OF MICROELECTROMECHANICAL SYSTEMS, IEEE SERVICE CENTER, US, vol. 8, no. 4, 1 December 1999 (1999-12-01), XP011034873, ISSN: 1057-7157, DOI: 10.1109/84.809055
- KHAN MUHAMMAD JEHANZEB ET AL: "Fabrication method of micromachined quartz glass resonator using sacrificial supporting structures", SENSORS AND ACTUATORS A: PHYSICAL, ELSEVIER BV, NL, vol. 305, 29 February 2020 (2020-02-29), XP086134821, ISSN: 0924-4247, [retrieved on 20200229], DOI: 10.1016/J.SNA.2020.111922

## Beschreibung

Die Erfindung betrifft eine mikromechanische Kammstruktur aus Glas mit einer Vielzahl an mikromechanischen Fingern, wobei die Kammstruktur in einer durch ein Glas-Substrat definierten Substrat-Ebene auslenkbar ist und wobei die Finger aus dem Glas-Substrat mittels laser induced deep etching (LIDE) freigeätzt wurden, also durch laserinduzierte Modifikation des Glas-Substrats und nachfolgende nasschemische anisotrope Ätzung freigelegt wurden. Mit anderen Worten schlägt die Erfindung somit eine monolithische Kammstruktur aus Glas vor, die mittels des LIDE-Verfahrens (vollständig / im Gesamten) definiert wurde, wobei die so entstandene Glas-Kammstruktur beweglich ausgestaltet ist und daher als Teil eines mikroelektromechanischen (MEMS) Sensors oder Aktors ausgestaltet sein kann.

Die Erfindung betrifft ferner einen mikromechanischen Aktuator (der insbesondere als Schrittaktuator ausgestaltet sein kann) auf Basis einer solchen Kammstruktur sowie ein Verfahren zum Herstellen einer solchen Kammstruktur. Schließlich schlägt die Erfindung noch eine spezifische Verwendung einer solchen Kammstruktur vor.

Relevanten technischen Hintergrund für solche Aktuatoren bilden die klassische Silizium-Mikromechanik, wie sie in dem beispielhaften Artikel "The Surface/Bulk Micromachining (SBM) Process: A New Method for Fabricating Released MEMS in Signle Crystal Silicon" von Lee et al., publiziert im Journal of Microelectromechnaical Systems, Vol.8, No.4, im Dezember 1999 beschrieben ist, Herstellungsmethoden, die Opferschichten einsetzen, wie in dem Artikel "Fabrication method of micromachined quartz glass resonator using sacrificial supporting structures" von Khan et al., publiziert in der Zeitschrift "Sensors and Acutators A: Physical" im Februar 2020 beschrieben, und klassische ablative Herstellungsmethoden die Laser einsetzen, wie beispielsweise in US 2022/0184744 A1 beschrieben, da alle diese Ansätze grundsätzlich als geeignet erscheinen, um mikromechanische Aktuatoren herzustellen. Der genannte Artikel von Lee et al. offenbart einen Resonator mit einem elektrostatischen Kammantrieb, wobei eine Kammstruktur in einer Ebene des Siliziumsubstrats auslenkbar ist. Das LIDE-Verfahren ist zwar vorbekannt, beispielsweise aus der Patentschrift EP 2964417 B1 oder aus dem Artikel "Bringing New Life to Glass for Wafer-Level Packaging Applications", by Rafael Santos et. al., veröffentlicht am 13. Oktober 2020 auf der "2020 International Wafer Level Packaging Conference (IWLPC)". Bislang wurde dieses Verfahren aber häufig eingesetzt, um Strukturen in Glassubstrate zu ätzen, die beispielsweise ein Gehäuse eines Sensors ausbilden, wie in dem Artikel im Detail beschrieben. Die Erfindung hat sich unter anderem damit beschäftigt, wie die Anwendungen des LIDE-Verfahrens ausgedehnt werden können. Beim LIDE-Verfahren wird mithilfe eines einzelnen Laserpulses, typischerweise über eine gesamte Dicke eines Glassubstrats hinweg, eine Materialänderung (Modifikation) in den Glaskörper (optisch) eingebracht, die dazu führt, dass in einem nachfolgenden nass-chemischen Ätzschritt, die so optisch mit dem Laser vorbehandelte/belichtete Struktur im Glassubstrat anisotrop geätzt werden kann, obwohl die Ätzlösung eigentlich isotrope Ätzeigenschaften zeigt. Mit dieser Technik können beispielsweise durchgehende Vias von hoher Qualität in Glas erzeugt werden, was für hermetische Aufbau- und Verbindungstechnik (AVT, bzw. hermetic packaging) von Interesse ist.

Beim LIDE-Verfahren können gepulste Laser eingesetzt werden, wobei dann mit jedem Laserschuss (ein Laserpuls) das Glas entlang der z-Richtung (= optische Achse/Flächennormale des Glas-Substrats) modifiziert wird. Hierbei wird typischerweise keinerlei Änderung des verwendeten Strahlprofils angewandt. Beim LIDE-Verfahren werden somit insbesondere keine einzelnen kleinen Volumina (Voxel) innerhalb des Glasvolumens mit dem Laser unterschiedlich bearbeitet, wie bei anderen laserbasierten (z.B. ablativen) Glasbearbeitungsverfahren.

Ausgehend von diesem vorbekannten Stand der Technik lag der Erfindung die Aufgabe zugrunde, mögliche Anwendungen des LIDE-Verfahrens auszuweiten.

Hierbei hat die Erfindung Folgendes erkannt: Die beim LIDE-Verfahren eingesetzte nasschemische Ätzung beginnt stets auf einer Substratoberfläche und schreitet von dort in die Tiefe (z-Richtung) des Glas-Substrats voran. Je nach gewählten Prozessparametern (insbesondere Material des Glassubstrats, verwendete Ätzlösung und Temperatur) kann dabei der Ätzradius r in der xy-Ebene (= Substratebene) entlang der z-Richtung (d.h. normal zur Substrat-Ebene) mehr oder weniger stark abnehmen, wodurch (zum Beispiel in der xz-Ebene) Kantenverläufe erzielbar sind, die eine Schräge in Bezug auf die z-Achse aufweisen. Hierbei sind stets nur solche Schrägen möglich, die einem abnehmenden Ätzradius r mit zunehmender Tiefe z entsprechen. Der Ätzradius r auf der Substratoberfläche ist jedoch stets gleich groß, da er nur von der Ätzlösung und der Gesamtätzzeit abhängt, und kann somit nicht ortsaufgelöst verändert werden, was eine zentrale Randbedingung des LIDE-Verfahrens darstellt. Die Erfindung hat ferner erkannt, dass die mögliche freie Platzierung der Laserpulse auf der Substratoberfläche eine äußerst genaue Strukturierung von Fingern einer mikromechanischen Kammstruktur erlaubt, die somit monolithisch ausgebildet werden kann, mit vorteilhaften mikromechanischen Eigenschaften, wie noch genauer erläutert wird.

Die optische Bearbeitung des Glas-Substrats erfolgt beim LIDE-Verfahren somit nicht-ablativ, d.h. der gewünschte Materialabtrag im Glas-Substrat wird erst später während des nasschemischen Ätzschritts erzielt, nicht aber mittels der Laserstrahlung. Ebenso kann beim LIDE-Verfahren auf Opferschichten verzichtet werden und es müssen auch nicht aufwändig Masken hergestellt werden, wie sie bei einer klassischen Photolithographie eingesetzt werden. Mit anderen Worten erfolgt beim LIDE-Verfahren die Laserbestrahlung des Glas-Substrats zur Ausbildung der besagten Modifikation maskenlos.

Für das LIDE-Verfahren kann weiter kennzeichnend sein (und dies kann erfindungsgemäß ausgenutzt werden), dass der eigentliche Ätzschritt, mit dem die Kammstruktur freigestellt wird, einstufig erfolgt, also in einem einzigen nasschemischen Ätzschritt erfolgt. Auf ein "thermal annealing", wie es bei bestimmten anisotrop ätzbaren Glassorten notwendig ist, kann beim LIDE-Verfahren ebenfalls verzichtet werden. All dies führt zu einer sehr effizienten und damit kostengünstigen Herstellung.

Mit dem LIDE-Verfahren können darüber hinaus noch weitere Glassubstrate bearbeitet werden, mit Hilfe derer sich die erfindungsgemäße mikromechanische Glas-Kammstruktur einhausen lässt. So kann beispielsweise eine Ausnehmung oder zusätzliche Perforationslöcher in dem jeweiligen weiteren Glassubstrat ausgebildet werden, etwa damit die Kammstruktur vor äußeren mechanischen Einflüssen geschützt ist, gleichzeitig beweglich bleibt, und zudem über die Perforationslöcher mit der Außenwelt kommuniziert. Durch den jeweiligen Ätzradius r(z), der in verschiedenen xy-Ebenen in unterschiedlicher z-Tiefe des Glas-Substrats erzeugt wird, können in den Seitenflächen (in Richtung der xz- bzw. yz-Ebene) charakteristische Einbuchtungen ausgebildet werden, die stets konkav ausfallen, weil die Ätzlösung in einer bestimmten xy-Ebene isotrop ätzt und somit eine konvexe Ätzfront ausbildet. Dadurch entstehen in diesen nasschemisch freigeätzten Seitenflächen hervorstehende Glas-Rippen, die zwischen den jeweiligen Einbuchtungen hervorstehen und die wie die Einbuchtungen entlang der z-Richtung verlaufen. Je nach gewählten Prozessparametern kann dabei nicht nur eine Schräge der Ausbuchtungen in der y-Richtung auftreten (z.B. bei einer in x-Richtung verlaufenden Struktur), sondern auch in x-Richtung (etwa an der Spitze eines solchen Struktur).

Es wurde ferner beobachtet, dass die Rippen, die eigentlich rein geometrisch scharfkantig ausfallen müssten, mit zunehmender Ätzdauer verrunden, was durch chemische Prozesse im Mikrobereich bedingt zu sein scheint. Die Rippen/ Ausbuchtungen zeigen dabei einen Abstand Lₓ, der dem Pulsabstand p entspricht, und zwar von denjenigen Laserpunkten, die für die Ausbildung der jeweiligen Ausbuchtung ursächlich sind. Da die Rippen/Ausbuchtungen ähnlich den Rippen auf der Außenseite einer Muschelschale erscheinen, können diese Strukturen als "sidewall scalloping" bezeichnet werden.Unter Berücksichtigung dieser Gesichtspunkte sind zur Lösung der obigen Aufgabe erfindungsgemäß bei einer mikromechanischen Kammstruktur die Merkmale von Anspruch 1 vorgesehen.

Somit ist erfindungsgemäß zur Lösung der Aufgabe bei einer mikromechanischen Kammstruktur aus Glas der eingangs genannten Art vorgesehen, dass bei der Herstellung der Finger Laserpulse, die eine äußere Kontur der Finger definieren, auf jeweiligen kontinuierlichen, insbesondere geradlinigen oder kurvenförmigen, sich gegenüberliegenden (realen oder aber bloß gedachten) Werkzeugbahnen (die der Kontur folgen) gesetzt wurden/werden, vorzugsweise in einem konstanten Pulsabstand p. Ferner ist vorgesehen, dass jede der Werkzeugbahnen einen (senkrechten) Maximalabstand r zu der Kontur, insbesondere zu konkaven Einbuchtungen der Kontur, aufweist, der gerade einem Ätzradius r eines nasschemischen Ätzschritts entspricht, der zum Freilegen der Finger eingesetzt wurde. Und schließlich weisen gemäß der Erfindung die Finger Seitenwandelektroden auf, um eine elektrostatische Aktuierung oder eine kapazitive Sensorik mit Hilfe der Kammstruktur zu realisieren.

Zur Ausbildung der beweglichen und monolithischen Kammstruktur aus Glas (die Finger können entweder passiv, etwa im Falle eines Sensors, oder aber aktiv, im Falle eines Aktors, beweglich sein) kann auch wenigstens ein Festkörpergelenk, über das die Kammstruktur, insbesondere einzelne Finger der Kammstruktur, auslenkbar und monolithisch mit dem Glas-Substrat verbunden ist, mittels des LIDE-Verfahrens (also durch laserinduzierte Modifikation des Glas-Substrats und nachfolgende nasschemische anisotrope Ätzung) definiert werden/sein.

Die Erfindung hat somit erkannt, dass das LIDE-Verfahren völlig neue Möglichkeiten eröffnet, um leistungsfähige MEMS auf Basis von Glas monolithisch mit gewünschten mikromechanischen Eigenschaften auszubilden. Dadurch muss nicht mehr wie bisher oftmals üblich auf ein zweites Substrat aus Silizium zurückgegriffen werden, in dem der eigentliche MEMS-Chip/die eigentliche Kammstruktur ausgebildet ist, sondern die gesamte Kammstruktur kann monolithisch in einem einzigen nasschemischen Ätzschritt in dem Glas-Substrat ausgebildet werden.

Hierbei ist es bevorzugt, wenn dabei alle Laserpulse, die die äußere Kontur von wenigstens einem (also unter Umständen auch zwei) der Finger in einem bestimmten Abschnitt dieses Fingers definieren, auf einer solchen (realen oder gedachten, kontinuierlichen der Kontur folgenden) Werkzeugbahn liegen. Jeder Laserpuls liegt dabei (senkrecht zur Werkzeugbahn) einer jeweiligen konkaven Einbuchtung in der Seitenwand des Fingers gegenüber. In diesem Fall wird die Kontur des Fingers auf einer Seite des Fingers somit ausschließlich durch Laserpulse vorgegeben, die auf einer einzigen kontinuierlichen Werkzeugbahn im Abstand r zu der Kontur, genauer im Abstand r zu den konkaven Einbuchtungen in der Seitenwand des Fingers, gesetzt werden/wurden. Entsprechend ergibt sich eine charakteristische Seitenwandstruktur des Fingers mit einem wie zuvor erläuterten sidewall scalloping. Die jeweilige Werkzeugbahn verbindet dabei benachbarte Laserpunkte miteinander und läuft somit kontinuierlich die Laserpunkte ab, die die Kontur definieren.

Ein einzelner Laserpunkt kann dabei unter Umständen auch die jeweilige Kontur von zwei direkt benachbarten Fingern der Kammstruktur definieren. Dies ist dann der Fall, wenn der Laserpunkt mittig zwischen die beiden benachbarten Finger gesetzt wurde. An der Stelle des Laserpunkts weisen die Finger demnach dann einen Abstand (an der Substratoberfläche) von D = 2r auf.

Durch eine solche Prozessführung bei der Herstellung können besonders schlanke Finger ausgestaltet werden. Dadurch kann ein hoher Füllfaktor, gemessen als Anzahl Finger / Fläche der Kammstruktur, erreicht werden, was günstig ist, um eine effiziente elektrische Aktuierung oder Sensorik auf Basis der Kammstruktur zu erzielen. Eine Kammstruktur mit derartigen Fingern lässt sich beispielsweise als elektrostatischer Mikroaktuator eines mikromechanischen Linear- oder Rotationsantriebs einsetzen.

Beim Definieren von größeren Kavitäten oder Vias in einem Glas-Substrat, wofür LIDE bereits eingesetzt wird, kommt es nicht darauf an, wo genau und in welcher Dichte die Laserpulse gesetzt werden, oder wie stark das sidewall scalloping ausgeprägt ist, weil dies keinen signifikanten Einfluss auf die ausgebildete Struktur hat. Dies ändert sich jedoch dramatisch, wenn mit dem LIDE-Verfahren, wie es die Erfindung vorschlägt, filigrane Finger eines Kammaktors definiert werden sollen. Denn wie noch genauer zu zeigen sein wird, werden dann durch die relative Lage der Laserpulse auf den sich beiden gegenüberliegenden Werkzeugbahnen als auch durch die Dichte der Laserpulse auf der jeweiligen Werkzeugbahn die mikromechanischen Eigenschaften der Finger signifikant beeinflusst (nämlich mit mehr oder weniger homogenen Eigenschaften).Wie erwähnt können die Laserpulse bevorzugt in einem konstanten Pulsabstand p auf der jeweiligen Werkzeugbahn platziert werden/sein, jedenfalls mindestens abschnittsweise (zum Beispiel Setzen von mind. 3 benachbarten Laserpulsen nacheinander im Pulsabstand p auf der jeweiligen Werkzeugbahn). Es versteht sich, dass je nach gewählten Ausmaß des sidewall scalloping die jeweilige Werkzeugbahn einen Mindestabstand von r-t_{y} zur Kontur aufweisen kann, mit t_{y} der Tiefe der jeweiligen Einbuchtung in der Seitenwand des jeweiligen Fingers.

Es kann ferner vorgesehen sein, dass die Finger jeweils zwei sich gegenüberliegende Seitenwände (die quer zur Substrat-Ebene verlaufen, also insbesondere in Richtung einer Flächennormale der Substrat-Ebene) ausbilden beziehungsweise aufweisen, die konkave Einbuchtungen zeigen. Diese Einbuchtungen zeigen dabei jeweils eine Krümmung mit einem Ätzradius r und/oder sind durch jeweilige konvexe Rippen begrenzt und/oder die Einbuchtungen und die Rippen verlaufen entlang einer Flächennormalen der Substrat-Ebene. Jeder Einbuchtung kann dabei einer derjenigen Laserpulse auf der zugehörigen Werkzeugbahn zugeordnet werden, die die äußere Kontur des Fingers definieren. Direkt benachbarte der Rippen können dabei zueinander einen Abstand Lₓ = p aufweisen, der gerade dem Pulsabstand p der zugehörigen Laserpunkte entspricht. Die besagten Rippen können typischerweise in z-Richtung, also normal zur Substrat-Ebene, verlaufen. Gleiches gilt auch für den Verlauf der Einbuchtungen selbst. Hierbei können die Rippen als auch die Einbuchungen eine Neigung zur z-Achse ausbilden, je nach dem gewählten Grad der Anisotropie des Ätzprozesses. Jede der Einbuchtungen kann hierbei einem zugehörigen Laserpunkt zugeordnet werden, der sich im Abstand r zur Kontur (= äußere Umrisslinie in der Substratoberfläche / auf der Oberseite der Biegestruktur) beziehungsweise zur Einbuchtung befand.

Bei einer solchen Ausgestaltung von Fingern mit sidewall scalloping ist es bevorzugt, wenn die Einbuchtungen - zumindest abschnittsweise, vorzugsweise jedoch entlang einer gesamten Länge des jeweiligen Fingers - einen konstanten / gleichbleibenden mittleren Abstand Lₓ zeigen (Lₓ ist somit der mittlere Abstand zwischen zwei direkt benachbarten der Rippen, die in derselben Seitenwand ausgebildet sind). Denn in diesem Fall können die Seitenwände gleichmäßig ausgebildet werden, was für eine präzise elektrostatische Aktuierung vorteilhaft ist.

Besonders vorteilhaft ist es ferner, wenn die Rippen einer äußeren gedachten Konturbahn folgen, die parallel verläuft zu einer Mittelachse (bei einem geradlinigen Finger) oder Mittellinie (bei einem gebogenen Finger) des jeweiligen Fingers. Denn dadurch kann eine Welligkeit der Konturbahn und damit eine Welligkeit der Seitenwände der Finger minimiert werden/sein. Bei Verwendung von gebogenen Fingern kann die Mittellinie des Fingers dabei bevorzugt in einer konstanten Krümmung verlaufen; gleiches gilt dann auch für die zugehörige Konturbahn. Bei einem geradlinigen Finger kann die Konturbahn hingegen bevorzugt geradlinig verlaufen.

Sich gegenüberliegende Rippen, die in sich gegenüberliegenden Seitenwänden eines jeweiligen der Finger ausgebildet sind, können so ausgebildet werden, dass sie einen Versatz Δx entlang einer Verlaufsrichtung des Fingers zeigen. Für diesen Versatz kann dann bevorzugt gelten: Lₓ/4 ≤ Δx ≤ Lₓ/2, mit Lₓ dem mittleren Abstand zwischen zwei direkt benachbarten der Rippen, die in derselben Seitenwand ausgebildet sind. Bei einer solchen Ausgestaltung wird die Breite B(x) der Finger - für ein gegebenes Ausmaß des sidewall scalloping - nur geringfügig schwanken, was günstig ist, um eine hohe Bruchfestigkeit und hohe Homogenität der mechanischen Eigenschaften des jeweiligen Fingers zu erreichen. Dies ist also ein erstes Beispiel, wie die genaue relative Platzierung der Laserpulse die mikromechanischen Eigenschaften der Finger beeinflusst.

Um die Seitenwände der Finger möglichst glatt auszugestalten kann ein schwach ausgeprägtes sidewall scalloping hilfreich sein. Denn so kann eine aufwändige Nach-Prozessierung der Finger nach dem nasschemischen Freilegen vermieden werden und zudem wird die Schwankung der Breite der Fingers entlang seiner Verlaufsrichtung geringer ausfallen, sodass die Steifigkeit des Fingers homogener ausfällt. Zur Erzielung eines schwach ausgeprägten sidewall scalloping können die Laserpulse so gesetzt werden und die Finger so freigeätzt werden, dass für ein Verhältnis aus einem mittleren Pulsabstand p zwischen benachbarten Laserpulsen auf einer der beiden Werkzeugbahnen und dem Ätzradius r, vorzugsweise entlang der gesamten Länge des jeweiligen Fingers, gilt: p < r, vorzugsweise p < r/2, besonders bevorzugt p < r/3. Dies ist ein weiteres Beispiel, wie die Dichte der Laserpulse auf der jeweiligen Werkzeugbahn die mikromechanischen Eigenschaften der Finger signifikant verändert.

Vorteilhaft an einer solchen Ausgestaltung ist auch, dass der Abstand zwischen gegenüberliegenden Fingern der Kammstruktur vergleichsweise geringe Schwankungen aufweist, weil bei nur schwach ausgeprägtem sidewall scalloping die Seitenflächen nur Einbuchtungen von geringer Tiefe zeigen und sich damit der Abstand (Spaltmaß) zwischen bei direkt benachbarten Fingern der Kammstruktur entlang der Längsrichtung des jeweiligen Fingers nur geringfügig (beispielsweise Variation < 10%) ändert. Dies wirkt sich günstig auf das Ansprechverhalten der Kammstruktur aus. Zudem können so homogene elektrische Streufelder erhalten und damit eine gleichmäßige Kraftentfaltung bei einer elektrostatischen Aktuierung der Kammstruktur sichergestellt werden. Bei sensorischen Anwendungen ergibt sich entsprechend eine gleichmäßige Sensorkennlinie (d.h. eine gleichmäßig generierte Ladungsverschiebung als Folge der Auslenkung der Finger).

Generell und gerade bei solchen Ausgestaltungen ist es zudem vorzuziehen, wenn direkt benachbarte der Laserpunkte (= Laserpulse) einen Mindestpulsabstand von wenigstens 3 um oder sogar wenigstens 5 um aufweisen. Denn dadurch können optische Abschattungseffekte vermieden werden und ein homogenes Ätzergebnis erzielt werden, was dafür sorgt, dass das Ausmaß des sidewall scalloping reproduzierbar und gezielt eingestellt werden kann.

Für ein Verhältnis aus dem lokalen Ätzradius r und einer lateralen Tiefe t_{y} der jeweiligen Einbuchtungen kann beispielsweise gelten: t_{y}/r < 0,1, vorzugsweise t_{y} /r < 0,05.

Zusätzlich oder alternativ zu solchen Merkmalen kann für das Verhältnis aus maximaler Breite B des jeweiligen Fingers quer zu seiner Verlaufsrichtung und der lateralen Tiefe t_{y} gelten: t_{y} /B ≤ 0,1, insbesondere t_{y} /B ≤ 0,05. Auch solche Parameter der Kammstruktur resultieren in einer besonders effizienten elektrischen Aktuierung oder elektrischen Sensorik auf Basis der Kammstruktur, weil sich dadurch die mikromechanischen Eigenschaften der Finger verbessern: Eine solche Ausgestaltung schlägt somit ein besonders flach/wenig ausgeprägtes sidewall-scalloping vor, wodurch eine besonders geringe Schwankung der Breite der Biegestruktur und damit eine hohe Homogenität der Steifigkeit erreicht wird. Eine solche Ausgestaltung kann vorteilhaft sein, etwa um eine besonders hohe Bruchfestigkeit und damit besonders große Auslenkungen der Biegestruktur zu ermöglichen. Bei sensorischen Anwendungen kann hingegen die Sensitivität erhöht werden, mit dem die Biegestruktur mechanische Schwingungen erfassen kann.

Ein besonders schwaches Sidewall-scalloping wird insbesondere dann Vorteile für die Homogenität der mechanischen Eigenschaften der Kammstruktur mit sich bringen, wenn die Breite der Finger vergleichsweis gering ist, was dann zu einem entsprechend hohen Verhältnis aus t_{y}/B führt und zudem zu einer hohen Energiedichte der elektrostatischen Aktuierung / Sensorik.

Wie noch genauer erläutert werden wird, können die Finger der Kammstruktur auch durch beidseitiges nasschemisches Ätzen, also von zwei gegenüberliegenden Oberflächen des Glas-Substrats her, freigestellt werden. Daher können die Finger insbesondere einen rautenförmigen Querschnitt zeigen, der aus einer beidseitigen nasschemischen Ätzung des Glas-Substrats resultiert. Bei einer solchen Ausgestaltung kann eine maximale Breite Bₘₐₓ der Finger beabstandet zu einer Oberfläche des Glas-Substrats liegen, zum Beispiel in einer Mittelebene des Glas-Substrats, etwa wenn gleichzeitig (und gleichschnell) von beiden Seiten her geätzt wurde.

Abhängig vom gewählten Material für das Glassubstrat und der sonstigen Prozessparameter des Ätzschritts, die ebenfalls die Anisotropie der Ätzung beeinflussen, können Seitenflächen der Finger einen jeweiligen Taperwinkel φ in Bezug auf eine Flächennormale des Glas-Substrats ausbilden. Hierbei ist es für einen hohen Füllfaktor und eine effiziente Aktuierung vorzuziehen, wenn der Taperwinkel weniger als 6°, vorzugsweise weniger als 3°, beträgt.

Ein weiterer Prozessparameter ist die Wahl des Pulsabstands im Verhältnis zur Breite des einzelnen Fingers. Hier kann für ein Verhältnis aus einem, insbesondere minimalen oder maximalen, Pulsabstand p zwischen zwei benachbarten Laserpulsen bzw. Laserpunkten auf einer parallel zur jeweiligen Kontur des jeweiligen Fingers verlaufenden Werkzeugbahn und einer maximalen Breite B des jeweiligen Fingers, gemessen quer zu seiner Verlaufsrichtung, gelten: p/B < 0,5, vorzugsweise p/B < 0,3 oder sogar p/B < 0,2.

Die maximale Breite B des jeweiligen Fingers der Kammstruktur kann beispielsweise weniger als 100 um, insbesondere weniger als 50 um, betragen.

Ferner kann ein Spaltmaß zwischen zwei direkt benachbarten Fingern der Kammstruktur weniger als 50 um, insbesondere weniger als 30 um, betragen.

Um eine elektrostatische Aktuierung zu ermöglichen, können Seitenwände der Finger eine Metallisierung aufweisen, die der Ausbildung von Elektroden dient. Solche Elektroden können verwendet werden, um eine elektrostatische Aktuierung oder eine kapazitive Sensorik mit Hilfe der Kammstruktur zu realisieren.

Gemäß einer weiteren vorteilhaften Ausgestaltung kann vorgesehen sein, dass eine jeweilige räumliche Phasenlage ϕ(x) von jeweiligen Laserpulspaaren / Laserpunktpaaren bzw. sich gegenüberliegenden Rippen in Seitenwänden eines der Finger entlang einer jeweiligen Verlaufsrichtung des (jeweiligen) Fingers so gewählt ist, dass in einer bestimmten Aktuierungsstellung der Kammstruktur Rippen, die in Seitenwänden des Fingers ausgebildet sind, auf einer Seite fluchtend mit entsprechenden Rippen eines ersten direkt benachbarten Fingers und auf einer gegenüberliegenden Seite versetzt zu entsprechenden Rippen eines zweiten direkt benachbarten Fingers ausgebildet sind. Hierbei können sich gegenüberliegende Rippen des Fingers, der zwischen dem ersten und zweiten direkt benachbarten Finger liegt, einen Versatz Δx < Lₓ/4 zeigen, insbesondere von Δx = 0.

Es versteht sich, dass in Bezug auf alle zuvor erwähnten Merkmale vorzugsweise sämtliche Finger der Kammstruktur jeweils wie für einen einzelnen Finger beschrieben ausgebildet sein können.

Im Extremfall, bei halbkreisförmigen Einbuchtungen, kann für die Länge Lₓ einer Einbuchtung gelten: Lₓ = p = 2r. In diesem Fall wäre also ein Verhältnis von p = 2r gewählt und das sidewall scalloping maximal ausgeprägt. Die Erfindung hat nun erkannt, dass dies zwar zu einer sehr großen Welligkeit der Seitenwände des jeweiligen Fingers führt. Diese Welligkeit kann aber, gerade bei einer elektrostatischen Aktuierung, ausgenutzt werden, um einen mikromechanischen Schrittmotor oder Schritt-Aktuator mit sehr kleiner und präziser Schrittweite zu realisieren. Die Erfindung schlägt daher einen mikromechanischen Schritt-Aktuator vor, der auf einer Kammstruktur aus Glas mit einer Vielzahl an Fingern basiert, die aus einem Glas-Substrat mittels laser induced deep etching (LIDE) freigeätzt wurden, also durch laserinduzierte Modifikation des Glas-Substrats und nachfolgende nasschemische anisotrope Ätzung freigelegt wurden. Diese Kammstruktur kann insbesondere wie zuvor beschrieben ausgestaltet sein. Ferner kann der Schritt-Aktuator vorzugsweise elektrostatisch aktuierbar sein (beispielsweise mittels der eingangs erwähnten Seitenwandelektroden, die an den Fingern ausgebildet sind).

Der Schritt-Aktuator zeichnet sich nun dadurch aus, dass eine Schrittgröße G des Schritt-Aktuators einem Abstand Lₓ von konvexen Rippen 9 entspricht (Lₓ = G), welche seitliche konkave Einbuchtungen 8 begrenzen, die in Seitenwänden der Finger ausgebildet sind und eine Krümmung mit einem Ätzradius r zeigen.

Um nun ein nicht-lineares Ansprechen des Schritt-Aktuators zu ermöglichen, kann insbesondere vorgesehen sein, dass für ein Verhältnis aus dem Ätzradius r und einer lateralen Tiefe t_{y} der jeweiligen Einbuchtungen gilt: t_{y} /r > 0.1, vorzugsweise t_{y} /r > 0.2, oder sogar t_{y}/r > 0.3. Ferner kann ergänzend oder alternativ zu diesen Merkmalen vorgesehen sein, dass für ein Verhältnis aus dem Abstand Lₓ (der weiterhin gleich der Schrittgröße G ist) und dem Ätzradius r gilt: Lₓ /r > 0,5, bevorzugt Lₓ /r > 0,7.

Ein solches Design der Kammstruktur resultiert in einem stark ausgeprägten sidewall scalloping und damit einer für einen Schrittantrieb gewünschten inhomogenen Kraftkennlinie des Schritt-Aktuators. Bei entsprechender Dimensionierung der Einbuchtungen kann so eine Schrittgröße im Bereich weniger um reproduzierbar vorgegeben werden, wobei die Schrittgröße durch die mittels des LIDE-Verfahrens festgelegte Geometrie der Kammstruktur festlegbar ist. Das Ausmaß des Ausprägung der sidewall scalloping bestimmt dabei, wie stark die Kraftkennlinie von einer linearen Kennlinie abweicht: je tiefer und ausgeprägter die konkaven Ausbuchtungen, umso treppenförmiger wird die Kraftkennlinie ausfallen.

Ein solcher Schritt-Aktuator auf Basis eines LIDE gefertigten Glas-Kammaktuators lässt sich beispielsweise einsetzen zur Positionierung einer optischen Komponente (Blende, Linse, Spiegel etc.) oder einer mechanischen Komponente (also als Mikro-Positionierer). Dieses Konzept stellt insbesondere eine Vereinfachung dar gegenüber vorbekannten "inchworm"-Aktuatoren auf Basis von Silizium-Technologie, die eine Vielzahl an Aktuierungselektroden, insbesondere Halteelektroden, benötigen, um einen Schrittantrieb (step drive) zu realisieren. Zudem bietet die Ausnutzung des LIDE-Verfahrens Kostenvorteile, insbesondere dann, wenn lange Stellwege über mehrere mm oder sogar cm erzielt werden sollen, weil sich Mikrostrukturen mit solchen Längenmaßen mittels LIDE kostengünstig fertigen lassen.

Bei einem wie oben beschriebenen Schritt-Aktuator kann ferner vorgesehen sein, dass eine jeweilige räumliche Phasenlage ϕ(x) von jeweiligen Laserpunktpaaren bzw. lateralen Einbuchtungen (11) entlang einer jeweiligen Verlaufsrichtung von direkt benachbarten der Finger der Kammstruktur ϕ = 0° +/- 60°, vorzugsweise ϕ = 0° +/-30°, insbesondere ϕ = 0° +/-5°, beträgt. Bei einer solchen Ausgestaltung kann beispielsweise erreicht sein, dass in einer bestimmten Aktuierungsstellung der Kammstruktur diejenigen Rippen, die in sich gegenüberliegenden Seitenwänden von je zwei direkt benachbarten Fingern ausgebildet sind, mindestens annähernd, vorzugsweise sogar vollständig, zueinander fluchten, und zwar vorzugsweise auf beiden Seiten des jeweiligen Fingers.

Mit den zuvor beschriebenen mikromechanischen Kammstrukturen lassen sich aber auch weitere mikromechanische Aktuatoren ausbilden wie etwa Linearantriebe oder Rotationsantriebe. Entsprechend schlägt die Erfindung auch einen mikromechanischen Aktuator vor, der eine wie zuvor beschriebene erfindungsgemäße Kammstruktur umfasst. Hierbei weisen die Finger der Kammstruktur, wie bereits eingangs erwähnt, Seitenwandelektroden zur elektrostatischen Aktuierung der Kammstruktur auf. Ferner ist es auch möglich, solche erfindungsgemäßen Kammstrukturen in einem kapazitiven Sensor als bewegliches kapazitives Sensorelement einzusetzen.

Zur Lösung der eingangs genannten Aufgabe wir auch ein Verfahren zur Herstellung einer mikromechanischen Kammstruktur aus Glas vorgeschlagen, wobei die Kammstruktur (mit dem Verfahren) mit Merkmalen wie zuvor erläutert ausgestaltet werden kann. Daher ist bei diesem Herstellungsverfahren auch vorgesehen, dass Seitenwandelektroden an den Fingern ausgebildet werden, um so eine elektrostatische Aktuierung oder eine kapazitive Sensorik mit Hilfe der Kammstruktur zu realisieren.

Die Kammstruktur weist demnach eine Vielzahl an mikromechanischen Fingern auf, wobei die Kammstruktur in einer durch ein Glas-Substrat definierten Substrat-Ebene auslenkbar ist und wobei die Finger aus dem Glas-Substrat mittels laser induced deep etching (LIDE) freigeätzt werden, also durch laserinduzierte Modifikation des Glas-Substrats und nachfolgende nasschemische anisotrope Ätzung freigelegt werden. Das Verfahren ist ferner dadurch gekennzeichnet, dass zum Freilegen der Finger Laserpulse, die eine äußere Kontur der Finger definieren sollen, auf jeweiligen kontinuierlichen, insbesondere geradlinigen oder kurvenförmigen, sich gegenüberliegenden Werkzeugbahnen gesetzt werden, vorzugsweise in einem konstanten Pulsabstand p, und dass anschließend alle Finger der Kammstruktur in einem gemeinsamen nasschemischen Ätzschritt freigelegt werden, sodass eine jeweilige äußere Kontur der Finger (also des jeweiligen Fingers) einen Maximalabstand r zu der zugehörigen Werkzeugbahn aufweist, der einem Ätzradius r des Ätzschritts entspricht.

Zur Herstellung der Kammstruktur können somit Laserpunkte auf jeweiligen Laserlinien platziert werden, die einen jeweiligen Abstand r zu einer Kontur des jeweiligen Fingers r aufweisen, der einem Ätzradius r eines nasschemischen Ätzschritts entspricht. Zur Fertigung der Kammstruktur kann beispielsweise im Rahmen des LIDE-Verfahrens vorgesehen sein, dass hierzu eine Reihe von Laserpunkten auf einer Laserlinie platziert werden/wurden, um mit Hilfe von Laserstrahlung eine Modifikation in das Glas-Substrat einzubringen. Bereiche des Glas-Substrats, die so mittels der Laserstrahlung modifiziert werden/wurden, können dann in dem nachfolgenden nasschemischen Ätzschritt freigeätzt werden/wurden. Die Finger der Kammstruktur weisen hierbei bevorzugt mikroskopische Abmessungen auf, etwa in Bezug auf eine Breite (in der Substrat-Ebene) und/oder Höhe (normal zur Substrat-Ebene) der Biegestruktur. Beispielsweise kann die Breite/Höhe im sub-mm Bereich liegen und etwa weniger als 100 µm, insbesondere weniger als 50 µm betragen. Die Länge der Finger kann hingegen vom Sub-mm-Bereich bis in den cm Bereich reichen.

Bei diesem Verfahren kann eine Anisotropie des Ätzschritts so gewählt sein, dass die Finger mit einem Taperwinkel φ von höchstens 6°, vorzugsweise von höchstens 3°, in Bezug auf eine Flächennormale der Substrat-Ebene ausgebildet werden. Hierbei ist es vorzuziehen, wenn ein Verhältnis aus einer ersten Ätzrate von mittels Laserstrahlung modifizierten Bereichen des Glas-Substrats und einer zweiten Ätzrate von nicht modifizierten Bereichen des Glas-Substrats größer 15:1, vorzugsweise von größer 20:1, gewählt ist.

Der Taperwinkel beschreibt somit die Schräge, die die jeweilige Seitenwand des Fingers zur Flächennormalen (z-Achse) der (xy-)Substrat-Ebene ausbildet.

Die Anisotropie der nasschemischen Ätzung, also das Verhältnis aus Ätzrate der mittels Laserstrahlung modifizierten Bereiche und derjenigen der nicht modifizierten Bereiche des Glassubstrats, kann über die Ätzchemie eingestellt werden. Beispielsweise kann Flusssäure oder Laugen wie KOH oder NaOH verwendet werden, um ein möglichst langsames Ätzen der nichtmodifizierten Bereiche und damit eine hohe Anisotropie zu erreichen. Zudem können langsam ätzende Glassorten wie etwa Borofloat-Glas oder Quarzglas (fused silica) eingesetzt werden.

Bei diesem Verfahren können die Finger ferner mit einer rautenförmigen Querschnittsform freigestellt werden, indem von zwei Seiten des Glas-Substrats her mit einer nasschemischen Ätzlösung geätzt wird. Dies kann vorteilhaft sein, um ein hohes Aspektverhältnis der Finger (das Aspektverhältnis (= Höhe/Breite der Finger) kann beispielsweise mehr als 10:1, oder sogar mehr als 50:1 betragen) zu erzielen, was sowohl für Aktorik als auch Sensorik Vorteile bietet. Hierbei kann die Anisotropie des Ätzschritts beispielsweise so eingestellt sein, dass die Finger nach dem Ätzen einen Innenwinkel in Bezug auf eine jeweilige Seitenwand von wenigstens 170° ausbilden. Ferner ist es für eine vereinfachte Prozessführung bevorzugt, wenn jeweils dieselbe nasschemische Ätzlösung, vorzugsweise und näherungsweise gleiche Prozessparameter wie etwa Konzentration und/oder Temperatur der Ätzlösung, verwendet wird/werden, um beide Seiten des Glas-Substrats zu ätzen. Die beidseitige Ätzung kann somit in einem einzigen Ätzschritt vorgenommen werden.

Bei einer senkrechten Ätzung (die jedoch nasschemisch nur näherungsweise erzielbar ist, weil die Ätzlösung das unbehandelte Glas isotrop ätzt) würden die Seitenwände senkrecht verlaufen und somit eine Innenwinkel von 180° zeigen. Es versteht sich zudem, dass zur Definition der modifizierten Bereiche im Glas-Substrat, die nasschemisch freigeätzt werden sollen, auch Laserpulse von beiden Seiten des Glassubstrats her, also auf beide sich gegenüberliegenden Oberflächen des Glas-Substrats, gesetzt werden können.

Bei dem Verfahren kann zur Erzielung eines schwach ausgeprägten sidewall scalloping vorgesehen sein, dass die Laserpunkte so gesetzt werden und die Finger so freigeätzt werden, dass für ein Verhältnis aus einem mittleren Pulsabstand p zwischen benachbart platzierten Laserpunkten und einem Ätzradius r, vorzugsweise entlang einer gesamten Länge des jeweiligen Fingers, gilt: p < r, vorzugsweise p < r/2.

Wie bereits erwähnt, kann eine jeweilige Kontur der Finger seitliche konkave Einbuchtungen in Folge der nasschemischen Ätzung zeigen, die jeweils eine Krümmung mit einem Ätzradius r an einer Oberfläche des Glas-Substrats zeigen und die durch jeweilige konvexe Rippen begrenzt sind. Entsprechend kann auch bei dem Verfahren die Prozessführung so gestaltet werden, dass für ein Verhältnis aus dem lokalen Ätzradius r und einer lateralen Tiefe t_{y} der jeweiligen Einbuchtungen gilt: t_{y} /r < 0.1, vorzugsweise t_{y} /r < 0.05. Ferner kann zusätzlich oder ergänzend für das Verhältnis aus maximaler Breite B des jeweiligen Fingers quer zu seiner Verlaufsrichtung und der lateralen Tiefe t_{y} gelten: t_{y} /B ≤ 0,1, insbesondere t_{y}/B ≤ 0,05.

Das Verfahren kann auch das Aufbringen einer Metallisierung umfassen. Somit kann eine Metallisierung, die der Ausbildung von Elektroden der Finger dient (unter Verwendung einer Schattenmaske oder eines Sprüh-Photolacks oder eines laminierbaren Trocken-Photolacks, jeweils als Maskierungsschicht) auf Seitenwände der Finger aufgebracht werden. Das Abscheiden der Metallisierung auf den Seitenwänden kann bevorzugt mittels physical vapor deposition (PVD), insbesondere mittels Sputtern, geschehen.

Schließlich schlägt die Erfindung noch eine spezifische Verwendung einer mikromechanischen Kammstruktur aus Glas in einem portablen elektronischen Gerät vor. Auch diese Kammstruktur ist erfindungsgemäß wie zuvor beschrieben hergestellt und/oder ausgestaltet, das heißt, die Kammstruktur weist insbesondere die bereits zuvor beschriebenen Seitenwandelektroden an den Fingern der Kammstruktur auf. Bei dieser Verwendung ist vorgesehen, dass die Kammstruktur Teil eines elektrostatischen Aktuators und/oder Teil eines kapazitiven Sensors ist und dazu eingesetzt wird, eine elektrostatische Haltekraft energiesparsam auszuüben bzw. aufrechtzuerhalten. Hierbei können die Finger der Kammstruktur eine jeweilige Länge von > 500 µm, insbesondere von größer 1 mm, aufweisen.

Durch die Ausbildung von langen Fingern, die ein nur schwach ausgeprägtes sidewall scalloping aufweisen, kann so eine elektrostatische Anordnung (Interdigitalstruktur/ Kammstruktur) erhalten werden, die eine quasi-statische Aktuierung - mit nur minimalem Stromverbrauch (aufgrund sehr geringer Leckströme) und damit das Ausüben vergleichsweise großer (mikroskopischer) Haltekräfte mit Hilfe einer elektrischen Spannung ermöglicht. Anders wie etwa bei einer elektromagnetischen Aktuierung können so größere Betriebsströme zur Aufrechterhaltung der Haltekraft vermieden werden. Dies ist sowohl für energiesparsame Sensorik wie Aktorik nützlich und kann gerade in einem portablen (energieautarken) Gerät Vorteile bieten.

Auch bei einer quasistatischen Aktuierung erscheint zudem ein minimales sidewall scalloping vorteilhaft, um die Bruchfestigkeit von in der Aktorik verwendeten mikromechanischen Federn (die wie hierin beschrieben ausgebildet werden können), insbesondere Torsionsfedern, zu steigern. Eine quasistatische Aktuierung ist zudem gerade für Mikrospiegel hochinteressant, zum Beispiels zur Anwendung in einem 3D-Trackersystem. Auch dies sind folglich Anwendungen, in denen erfindungsgemäße Kammstrukturen zum Einsatz kommen können.

Die Erfindung wird nun anhand von Ausführungsbeispielen näher beschrieben, ist aber nicht auf diese Ausführungsbeispiele beschränkt. Weitere Ausbildungen der Erfindung können aus der nachfolgenden Beschreibung eines bevorzugten Ausführungsbeispiels in Verbindung mit der allgemeinen Beschreibung, den Ansprüchen sowie den Zeichnungen gewonnen werden. Bei der folgenden Beschreibung verschiedener Ausführungsformen der Erfindung erhalten in ihrer Funktion übereinstimmende Elemente auch bei abweichender Gestaltung oder Formgebung übereinstimmende Bezugszahlen.

Es zeigt:
- Fig. 1: ein erstes (schematisches) Beispiel eines erfindungsgemäß ausgestalteten Fingers eines mikromechanischen Kammaktuators in Glas,
- Fig. 2: ein weiteres Beispiel eines Fingers eines erfindungsgemäßen mikromechanischen Kammaktuators in Glas,
- Fig. 3: ein weiteres Beispiel eines Fingers eines erfindungsgemäßen mikromechanischen Kammaktuators in Glas,
- Fig. 4: eine detaillierte und schematische Ansicht der äußeren Kontur eines Teilabschnitts eines Fingers eines erfindungsgemäßen mikromechanischen Kammaktuators,
- Fig. 5: einen Graphen, der die Breite B (x) eines Fingers des Kammaktuators als Funktion der x-Position für drei Fälle von unterschiedlich ausgebildeten Phasenlagen ϕ(x) zeigt,
- Fig. 6: eine weitere schematische Illustration eines Teilabschnitts eines Fingers eines erfindungsgemäßen Kammaktuators,
- Fig. 7: ein Teilabschnitt eines mikromechanischen Federelements, welches vollständig in den Figuren 14 und 16 gezeigt ist,
- Fig. 8: eine weitere schematische Aufsicht ähnlich den Figuren 1-3, auf einen einzelnen Finger eines erfindungsgemäßen Kammaktuators, wobei zahlreiche Design- bzw. Prozessparameter illustriert sind,
- Fig. 9: eine Rasterelektronenmikroskop (REM)-Aufnahme einer erfindungsgemäßen mikromechanischen Kammstruktur die zahlreiche Finger aufweist, die gemäß der Erfindung ausgestaltet sind und
- Fig. 10: eine Rasterelektronenmikroskop (REM)-Aufnahme eines einzelnen Fingers einer erfindungsgemäßen mikromechanischen Kammstruktur,
- Fig. 11: eine Querschnittsansicht eines Fingers einer erfindungsgemäßen Kammstruktur mit mittlerem Taperwinkel,
- Fig. 12: eine Querschnittsansicht eines Fingers einer erfindungsgemäßen Kammstruktur mit größerem Taperwinkel,
- Fig. 13: eine weitere Querschnittsansicht eines Fingers einer erfindungsgemäßen Kammstruktur mit äußerst geringem Taperwinkel,
- Fig. 14: eine Draufsicht auf eine erfindungsgemäße mikromechanische Kammstruktur, die mittels des LIDE-Verfahrens in einem Glas-Substrat freigelegt wurde,
- Fig. 15: eine zu der Kammstruktur der Figur 14 korrespondierende Metallisierung (gezeigt ist die Öffnung der verwendeten Schattenmaske), die auf die Kammstruktur aufgebracht wird,
- Fig. 16: ein mittels der mikromechanischen Kammstruktur aus Figur 14 realisierter elektrostatischer Rotationsantrieb, der ein Endstück rotieren kann, welches an einem mikromechanischen Federelement drehbar aufgehängt ist, die
- Fig. 17 und Fig. 18: illustrieren, wie das sidewall scalloping an Fingern der Kammstruktur gezielt eingestellt werden kann, um eine gleichmäßige Aktuierung zu ermöglichen und
- Fig. 19: zeigt grundlegende Möglichkeiten zum Setzten von Laserpulsen zum Herstellen einer Kammstruktur.

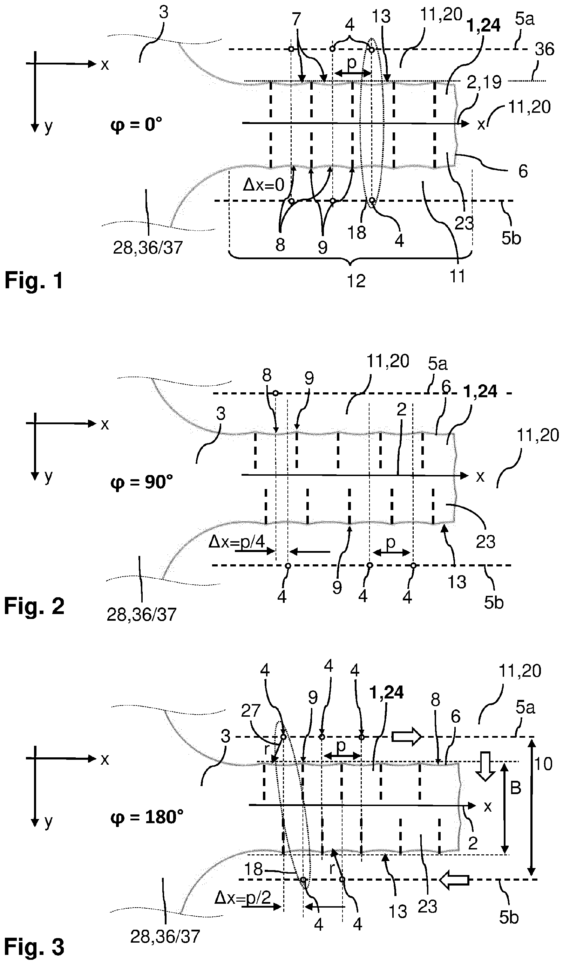

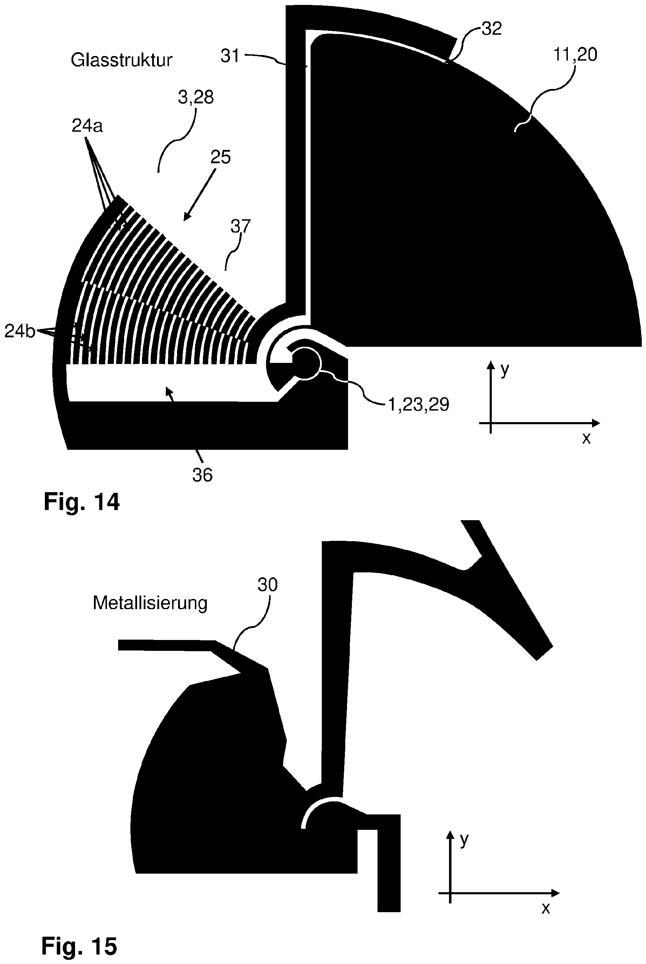

Die Figur 1 zeigt schematisch eine mit Hilfe des LIDE (laser induced deep etching) Verfahrens freigelegte mikromechanische Mikrostruktur 1 in Form eines Fingers 24, der aus einem Glas-Substrat 3 in Form eines Glas-Wafers mittels nasschemischer Ätzung freigelegt wurde. Die Ansicht der Figur 1 ist dabei eine Ansicht von oben auf die xy-Ebene des Glas-Substrats 3, welches eine bestimmte Substratdicke t_{glas} in z-Richtung aufweist. Wie zu erkennen, ist der Finger 24 einseitig mit einer größeren Anker-Struktur verbunden, die Teil des Glas-Substrat 3 ist. Dieser Anker 36/37 kann im Verhältnis zum Glas-Substrat 3 statisch sein oder aber beweglich gelagert, beispielsweise mittels eines mikromechanischen Federelements 29 (Vgl. Figur 14). Ist letzteres der Fall, kann der Finger 24 somit in der xy-Ebene auslenkbar sein, beispielsweise in einer Linear- oder in einer Rotationsbewegung.

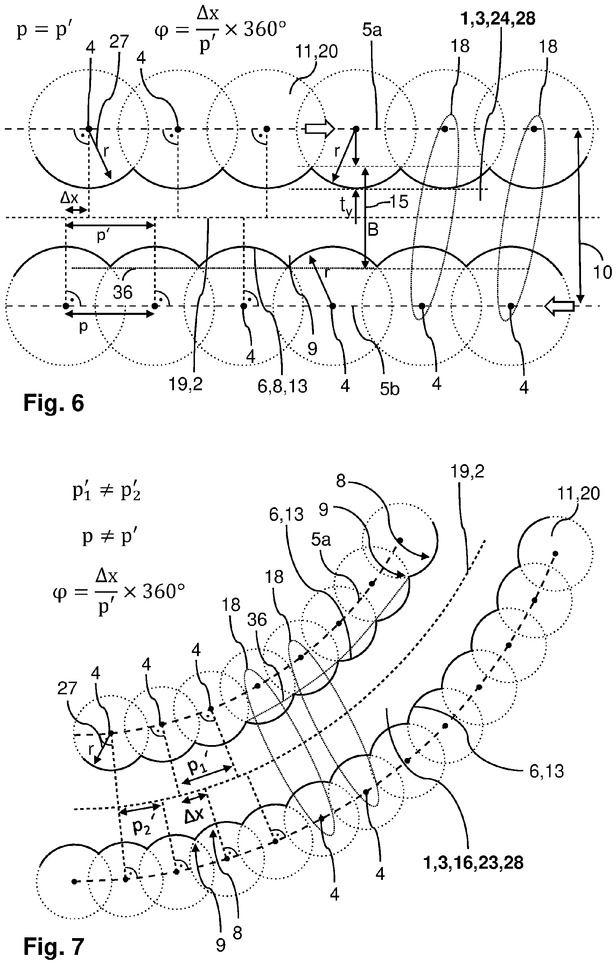

Mittels des LIDE (laser induced deep etching) Verfahrens ist es möglich, feine Glasstücke aus einem Glas-Substrat 3 auszuschneiden bzw. freizulegen. Dazu wird zunächst mithilfe eines Lasers eine Kontur 6 abgefahren, die die äußere Begrenzung der freizulegenden Mikrostruktur 1, etwa des Fingers 24 aus Figur 1, beschreibt. Hierzu wird vorgeschlagen einen Laserkopf, der einen gepulsten Laserstrahl ausgibt, auf einer zugehörigen Werkzeugbahn 5a, 5b zu verfahren, die der Kontur 6 in einem bestimmten Abstand folgt (Vgl. Figur 3). Da der Laser jedoch gepulst wird, wird das Glas-Substrat 3 vom Laserstrahl nicht kontinuierlich beleuchtet, sondern es werden einzelne Laserpulse 4 an bestimmten xy-Koordinaten auf der Oberfläche des Glassubstrats 3 als Laserpunkte 4 gesetzt. Hierbei können die Laserpunkte 4 einen konstanten geometrischen Pulsabstand p (gemessen in um in der Substrat-Ebene) aufweisen und/oder allesamt auf der besagten Werkzeugbahn 5a, 5b liegen. Die Blockpfeile in Figur 3 sollen dabei angeben, in welcher Reihenfolge die Werkzeugbahnen 5 abgefahren und die Laserpunkte 4 gesetzt werden (Vgl. auch Figur 6).

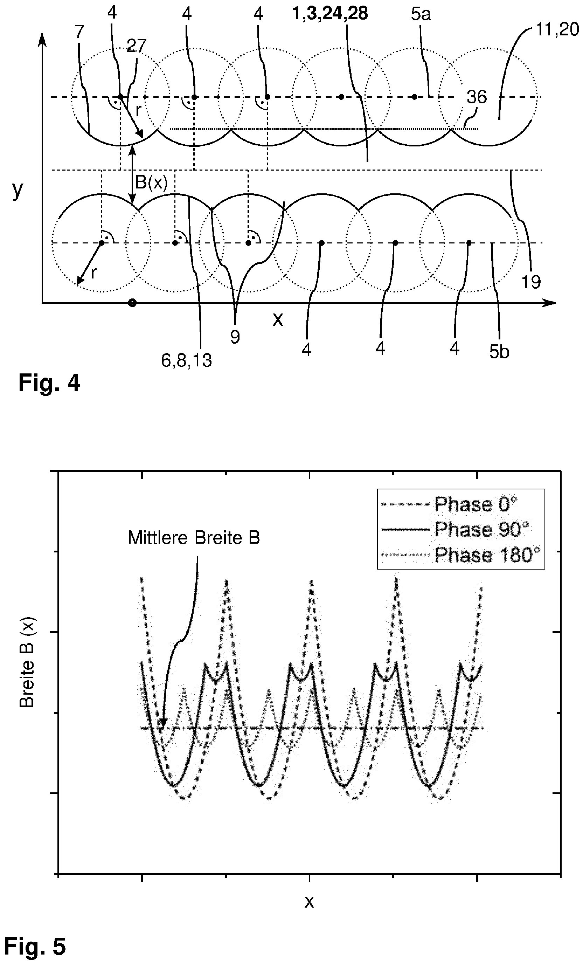

Soll beispielsweise ein länglicher Schlitz im Glassubstrat 3 angelegt werden, so wird eine gewisse Anzahl von Laserpulsen 4 entlang einer Werkzeugbahn 5 platziert, jeweils im Pulsabstand p, wobei typischerweise mit jedem Laserpuls 5 das Glassubstrat 3 über die gesamte Dicke modifiziert wird. Im nachfolgenden nass-chemischen Ätzprozess frisst sich die Ätzlösung von der Oberfläche her in z-Richtung in das Substrat 3, wobei die Ätzgeschwindigkeit in der xy-Ebene isotrop ist, sodass sich an der Oberfläche ein kreisscheibenförmiges Ätzprofil 7 mit Rotationssymmetrie um einen jeweiligen Laserpunkt 4 herum ausbildet (vgl. die Kreise in den Figuren 4 sowie 6 bis 8). Dies hat zur Folge, dass die final freigeätzte Kontur 6 der Mikrostruktur 1 einen Abstand r (= Ätzradius 27) zeigt zum Zentrum des ursprünglichen Laserpunkts 4 (Vgl. Fig. 3 oder Figur 6). Anders ausgedrückt zeigt die freigeätzte Konturlinie 6 des Fingers 24 in Figur 1 an der Oberfläche des Glas-Substrats 3 einen Maximalabstand r zu der (auf die Substrat-Ebene projizierten) Werkzeugbahn 5, auf welcher die Laserpulse 4 platziert wurden.

Aufgrund der Ätzradien r entstehen dabei in der jeweiligen Seitenwand 13 der Finger 24 (Vgl. die Figuren 1-3) konkave Einbuchtungen 8, die jeweils eine Krümmung mit dem Ätzradius r 27 zeigen und die durch jeweilige konvexe Rippen 9 begrenzt sind, wobei diese Rippen 9 aber auch die Einbuchtungen 8 entlang der z-Richtung verlaufen (Vgl. Figuren 1-3 sowie 4, 6 sowie 11-13). Diese beim nasschemischen Freilegen der Finger 24 entstehenden Strukturen in der jeweiligen Seitenwand 13 werden als sidewall scalloping bezeichnet, da die Einbuchtungen 8 bzw. die dazwischen liegenden Rippen 9 eine Struktur ähnlich wie auf der Innenseite einer Muschelschale ausbilden.

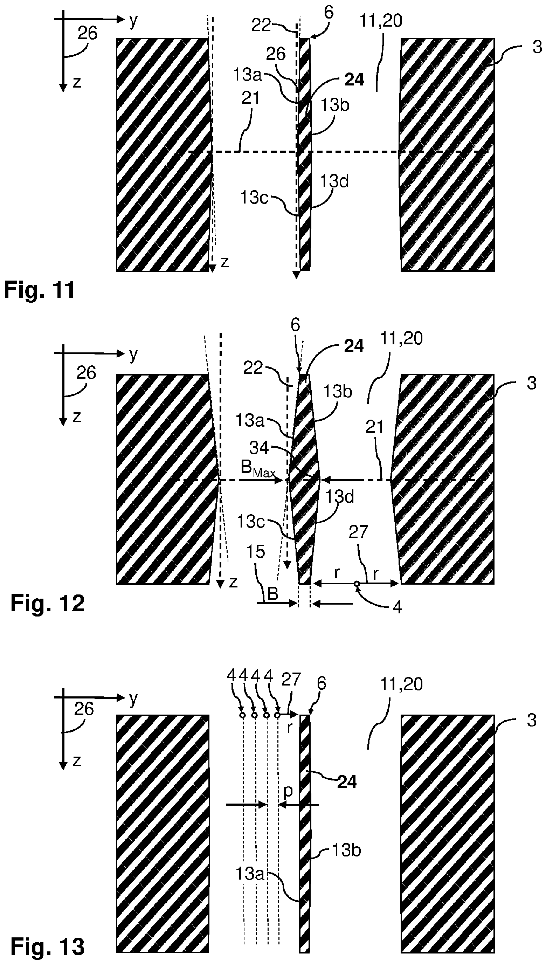

Je nach gewählten Prozessparametern und damit dem Grad der Anisotropie der nasschemischen Ätzung kann dabei der Ätzradius 27 r in der xy-Ebene entlang der z-Richtung (d.h. normal zur Substrat-Ebene) mehr oder weniger stark abnehmen, wodurch (zum Beispiel in der xz-Ebene) Verläufe der Seitenwände 13 der Finger 24 erzielbar sind, die eine Schräge aufweisen beziehungsweise einen Taperwinkel 22 φ in Bezug auf die z-Achse ausbilden, wie dies in den Figuren 11-13 illustriert ist. Auch im Falle der Figur 12 besteht somit ein Taperwinkel, und zwar dort über die gesamte Höhe des Fingers 24, dieser ist jedoch nur äußerst schwach ausgeprägt. Auf der Substratoberfläche ist der Ätzradius 27 r jedoch, ausgehend von jedem Laserpunkt 4, stets gleich groß. Ferner sind stets nur solche Schrägen möglich, die einem abnehmenden Ätzradius 27 r mit zunehmender Tiefe z entsprechen. Dies ergibt sich aus der Tatsache, dass die nass-chemische Ätzung stets auf der Substratoberfläche beginnt und von dort aus in die Substrattiefe voranschreitet. Allerdings ist es möglich diesen Prozess entweder einseitig (Fig. 13) oder aber beidseitig (Vgl. Figur 11 und 12) von beiden Substratoberflächen aus zu starten, sodass sich in letzterem Fall dann entsprechend symmetrische Schrägen ergeben, die jeweils in Richtung auf eine (in z-Richtung) mittig angeordnete Ebene 21 (die parallel zur xy-Ebene liegt) zulaufen (Vgl. Figur 12).

Wie in Figur 12 angedeutet ist, die einen Querschnitt durch einen Finger 24 eines erfindungsgemäßen Kammaktuators 25 zeigt (wobei die Verlaufsrichtung 2 der Mikrostruktur 1/des Fingers 24 in Blickrichtung auf die Zeichnung verläuft), kann bereits ein einzelner Laserpunkt 4 ausreichen, um einen Schlitz mit einer Breite 2r zwischen einem Finger 24 und einem benachbarten Finger 24 oder dem bulk des Glas-Substrats 3 zu definieren, wobei die Ätzlösung dann ausgehend von dem Laserpunkt 4 (zum Beispiel wie in Figur 12 in positiver und negativer y-Richtung) an der Oberfläche des Glas-Substrats 3 beidseitig einen Ätzradius 27 r ausbildet. Dabei kann die an der Oberfläche des Glas-Substrats 3 gemessene maximale Breite B 15 des jeweiligen Fingers 24 (gemessen quer zur Verlaufsrichtung 2, also in y-Richtung in Figur 12) erheblich abweichen von der maximalen Breite B_{Max}, die der Finger 24 in der illustrierten Mittelebene 21 des Substrats 3 zeigt, je nach gewähltem Taperwinkel φ 22 (Vgl. Figur 12).

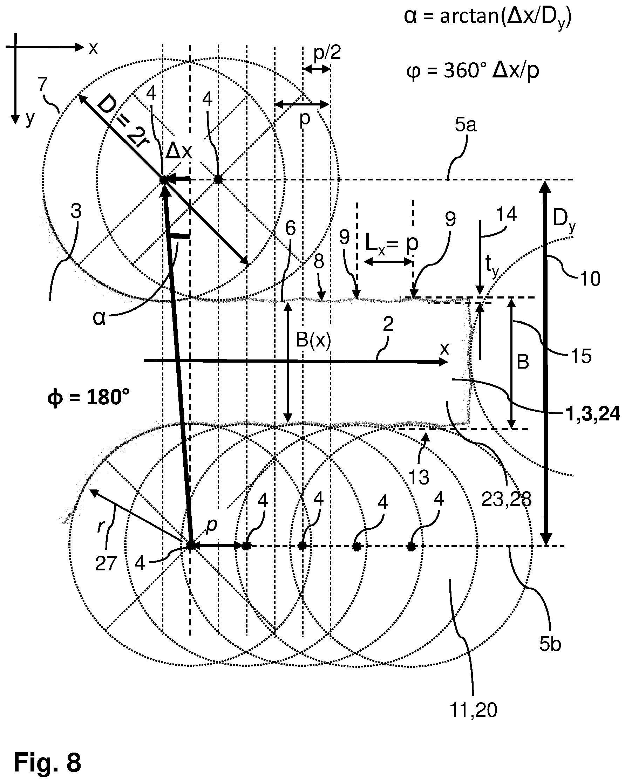

Wie die Figur 12 illustriert, können aber auch Laserpunkte 4 in sehr engem Pulsabstand p nebeneinandergesetzt werden, sodass sich dann die resultierenden Ätzradien r überlappen (vgl. dazu auch Figur 8). Ist die Anisotropie der laserinduzierten nasschemischen Ätzung sehr hoch gewählt, lassen sich nahezu senkrechte Seitenwände 13 der Finger 24 der Kammstruktur 25 definieren, wie in Figur 13 gezeigt (dort ist der Taperwinkel 22 äußerst gering ausgeprägt).

Die Figur 8 illustriert im Detail, wie der Finger 24 der Figur 3 gefertigt wurde. Wie anhand der Kreise zu erkennen ist, die jeweils das kreisscheibenförmige Ätzprofil 7 mit dem Ätzdurchmesser D = 2r illustrieren, wurden eine ganze Reihe von Laserpulsen 4 auf zwei sich gegenüberliegenden Werkzeugbahnen 5a und 5b platziert. Da sich die Ätzfront 7 in der xy-Substrat-Ebene isotrop ausbreitet, weisen die Laserpulse 4 jeweils einen Abstand r zu der finalen äußeren Kontur 6 des Fingers 24 auf, der gerade dem Ätzradius 27 r des zum Freilegen des Fingers 24 verwendeten nasschemischen Ätzschritts entspricht. Wie die Figur 3 zeigt, können jeweils zwei Laserpulse 4, die auf den sich gegenüberliegenden Werkzeugbahnen 5a und 5b liegen, zu einem Laserpulspaar 18 zusammengefasst werden. Wie die Figuren 1-3 und 8 zeigen, können die beiden Laserpulse 4 eines jeweiligen Laserpulspaars 18 - in Bezug auf die Verlaufsrichtung 2 des Fingers 24, die in diesen Figuren der x-Achse entspricht - einen Versatz Δx zeigen, der zum Beispiel zwischen Δx = 0 und Δx = p/2 liegen kann bei Verwendung eines konstanten Pulsabstands p.

Je nach Ausmaß dieses Versatzes Δx ergibt sich eine räumliche Phasenlage ϕ(x) bzw. ein räumlicher Phasenverzug ϕ(x) zwischen den jeweiligen Laserpunkten 4 eines Laserpunktpaares 18. Beim Beispiel der Figur 1 beträgt der Versatz Δx = 0 und somit sind dort die Laserpunkte 4 des jeweiligen Laserpunktpaares 18 gerade in Phase (ϕ = 0°) angeordnet in Bezug auf die Verlaufsrichtung 2. Beim Beispiel der Figur 3 ist der Phasenunterschied hingegen maximal (ϕ = 180°), denn der Versatz Δx beträgt dort Δx = p/2, mit p dem Pulsabstand, also dem Abstand zwischen zwei direkt benachbarten Laserpunkten, die auf derselben Werkzeugbahn (z.B. 5b) platziert sind - vgl. dazu Figur 8.

Das Verhältnis p/r aus Pulsabstand p und Ätzradius 27 r bestimmt hingegen, wie stark die Einbuchtungen 8 des sidewall scalloping ausgeprägt sind. Der Abstand zwischen den Rippen 9 entlang der x-Achse Lₓ entspricht dabei gerade dem Pulsabstand Lₓ = p - vgl. Figur 8. Zudem kann für jede Einbuchtung 9 eine laterale Tiefe t_{y} 14 bestimmt werden, und zwar gemessen quer zur Verlaufsrichtung 2, also in der y-Richtung in Figur 8.

In Figur 8 ist zudem illustriert, dass die beiden Werkzeugbahnen 5a und 5b einen Abstand D_{y} 10 aufweisen. Dieser Abstand und der gewählte Versatz Δx bestimmen dabei den Schrittwinkel α, den zwei Laserpunkte 4 eines jeweiligen Laserpunktpaares 18 in Bezug auf die Verlaufsrichtung 2 ausbilden, wobei gilt α = arctan(Δx/D_{y}). Die räumliche Phasenlage ϕ(x) bestimmt sich hingegen zu ϕ = 360° Δx/p, wobei der Versatz Δx abhängig von der x-Koordinate des Laserpulspaars 18 variieren kann, sodass auch die Phasenlage ϕ(x) entlang der Verlaufsrichtung 2 grundsätzlich schwanken kann.

Die Figuren 4 und 6 illustrieren, wie sich das Ausmaß des sidewall scalloping, das beispielsweise am Verhältnis t_{y}/r abgelesen werden kann, auf die Homogenität der Breite B(x) des Fingers 24 und damit auch auf die mechanischen Eigenschaften auswirkt. Die drei Kurven des Graphen der Figur 5 illustrieren dabei, wie sich die Breite B(x) entlang der Verlaufsrichtung 2 mit der x-Koordinate ändert (und dabei jeweils an verschiedenen x-Stellen eine maximale Breite B 15 annimmt), und zwar für die drei Fälle einer Phasenlage von 0°/90°/180°, die in den Figuren 1-3 illustriert wurden. Wie die horizontale gestrichelte Linie in Figur 5 zeigt, wurden dabei drei Finger 24 verglichen, die jeweils die gleiche mittlere Breite B aufweisen. Auch das Ausmaß des sidewall scalloping (gemessen in t_{y}/r) wurde gleich groß gewählt. Man erkennt in dem Graphen der Figur 5, dass bei einer räumlichen Phase von ϕ=0° die Schwankung der Breite B (x) am größten ist.

Bei einer räumlichen Phasenlage von (p=180° zeigt der Finger 24 hingegen die geringste Schwankung der Breite B (x). Bei einer Phasenlagen von (p=180° ergeben sich somit nicht nur Vorteile hinsichtlich einer höheren Bruchfestigkeit, sondern bei gleicher mittlerer Breite B kann auch die Federsteifigkeit einer Mikrostruktur 1, die auf diese Weise hergestellt ist, signifikant reduziert werden, da diese (für Auslenkungen der Mikrostruktur in der Substrat-Ebene) kubisch von der Breite B abhängt. Dies wurde beispielsweise bei dem in Figur 7 gezeigten mikromechanischen Federelement 29 angewandt, welches Teil des elektrostatischen Aktuators 33 (auf Basis einer erfindungsgemäßen Kammstruktur 25) ist, der in Figur 14 gezeigt ist. Bei einer Phasenlage von ϕ=0° würde die lokale Federsteifigkeit hingegen erheblich schwanken, da die Schwankungen der Federbreite B mit dritter Potenz eingehen, wodurch Spitzen der mechanischen Spannung entstehen können, die einen Bruch der Feder 29 verursachen könnten.

Ein wie in Figur 3 illustrierter mikromechanischer Finger 24 aus Glas, der eine Phasenlage ϕ(x) von 180° und ein vergleichsweise schwach ausgeprägtes sidewall scalloping zeigt, ist daher hervorragend geeignet, um als Teil eines mikromechanischen Aktuators 33 oder Sensors verwendet zu werden, da diese Mikrostruktur 1 einerseits bruchfest ist und zudem homogene mechanische Eigenschaften aufweist. Aufgrund der dieser Eigenschaften lässt sich mit einer solchen Mikrostruktur 1 insbesondere eine hoch qualitative elektrostatische Aktuierung/Sensorik realisieren.

Aber auch beispielsweise eine Phasenlage von ϕ=0°, wie in Figur 1 gezeigt, kann, insbesondere dann, wenn das sidewall scalloping gerade stark ausgeprägt ist, zu interessanten mechanischen Eigenschaften führen, die sich gewinnbringend technisch in einem Kammaktuator 33 ausnutzen lassen. Beispielsweise kann eine hohe Schwankung der Breite B des Fingers 24 (wie für den Fall ϕ=0° in Figur 5 illustriert), zu einem starken nicht-linearen Ansprechverhalten der zugehörigen Kammstruktur 25 / des zugehörigen Aktuators 33 führen, die sich beispielsweise in einem Schrittmotor/Schritt-Aktuator ausnutzen lässt.

Wie man in den Figuren 1-3 gut erkennt, ist dort jedoch die jeweilige räumliche Phasenlage ϕ(x) der jeweiligen Laserpulspaare 18 entlang der Verlaufsrichtung 2 des Fingers 24 homogen eingestellt, wobei die Phasenlage in Figur 1 ϕ=0°, in Figur 2 ϕ=90° und in Figur 3 (p=180° beträgt. Aufgrund des jeweils gradlinigen Verlaufs des Fingers 24 schwankt die Phasenlage ϕ(x) dabei nur im Rahmen der Genauigkeit, mit der die Laserpunkte 4 auf dem Glas-Substrat 3 platziert werden können.

Wie die Figur 6 illustriert, entspricht bei einem geradlinigen Verlauf des Fingers 24 der effektive Pulsabstand p'=p gerade dem geometrischen Pulsabstand p zwischen zwei direkt auf einer Werkzeugbahn 5 benachbarten Laserpunkten 4.

Die Figur 7 zeigt ein Beispiel eines erfindungsgemäß ausgestalteten Federelements 29, welches zusammen mit einem erfindungsgemäßen Kammstruktur 25 verwendet werden kann, insbesondere um einen beweglichen Anker 36 der Kammstruktur 25 (der einen Teil der Finger 24 trägt) auslenkbar (also zum Beispiel drehbar wie in Figur 14 oder auch linear verschiebbar in der Substrat-Ebene 28 zu lagern. Das Federelement 29 zeigt einen kurvenförmigen Verlauf 2, was man anhand der Mittellinie 19 gut erkennen kann. Auch bei einer solchen Ausgestaltung können jeweilige Laserpunktpaare 18 betrachtet werden. Der effektive Pulsabstand p' ≠ p kann dann aber, wie in Figur 7 illustriert, von dem geometrischen Pulsabstand p abweichen. Dennoch kann auch bei einem derartigen Verlauf der Mikrostruktur 1 die jeweilige räumliche Phasenlage ϕ homogen eingestellt werden. Bei dem Beispiel der Figur 7 schwankt die Phasenlage, zumindest abschnittsweise, geringfügig (um ca. +/-30°) um eine mittlere Phasenlage von ca. ϕ = 180°.

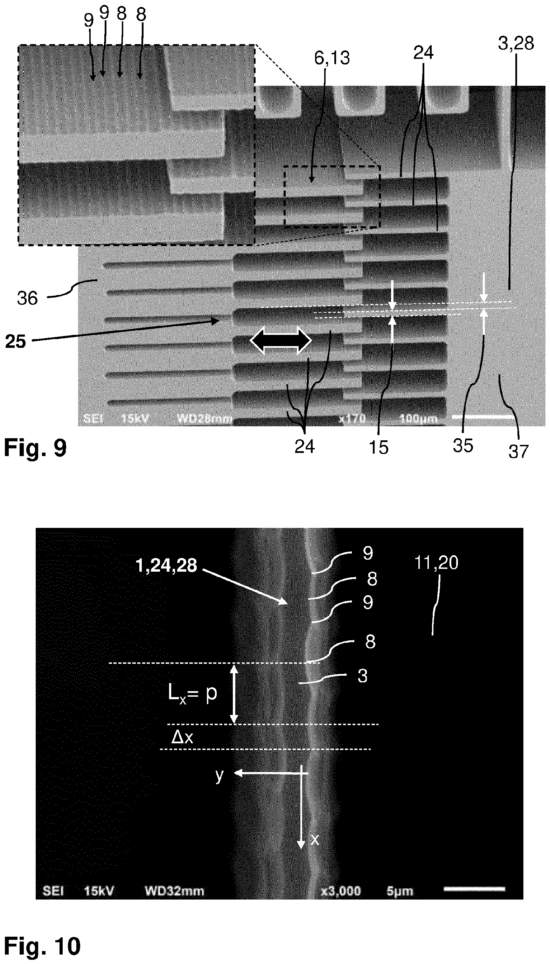

Die Figuren 9 und 10 zeigen jeweils eine Rasterelektronenmikroskop (REM)-Aufnahme in Schrägsicht von oben auf eine erfindungsgemäße mikromechanische Kammstruktur 25 (Figur 9) bzw. einen einzelnen Finger 24 (Fig. 10) einer solchen Kammstruktur 25. Gerade anhand der Detailansicht der Figur 9 aber auch in Figur 10 sind die Einbuchtungen 8 und die dazwischenliegenden Rippen 9, die jeweils in z-Richtung also quer zur Substrat-Ebene 28 verlaufen, gut zu erkennen. Bei dem Finger 24 der Figur 10 sind die Einbuchtungen 8 / Rippen 9 jeweils mit homogen eingestellter Phasenlage von ca. ϕ = 150° ausgebildet. Die linken Finger 24 der Kammstruktur 25 der Figur 9 sind dabei in ihrer jeweiligen Längsrichtung (= Verlaufsrichtung 2) beweglich, da diese Finger 24 an einem beweglich gelagerten Anker 36 angeordnet sind. Die linken Finger 24 können sich somit mehr oder weniger tief in die Zwischenräume hinein bewegen (vgl. den Blockpfeil), die zwischen den rechten Fingern 24 ausgebildet sind, die an einem statischen Anker 37 angeordnet sind.

Die Figur 14 zeigt ein Beispiel, wie eine erfindungsgemäße Kammstruktur 25 in einem Glas-Substrat 3 mittels des LIDE-Prozesses freigestellt werden kann. Die schwarzen Flächen markieren dabei diejenigen Bereiches des Glas-Substrats 3, die mittels des Lasers modifiziert und anschließend in einem Ätzschritt freigeätzt wurden. Die hellen Strukturen markieren hingegen die Glas-Strukturen, die nach dem Ätzen stehen geblieben sind.

Um die Kammstruktur 25 elektrostatisch aktuieren zu können, wird eine Seitenwandmetallisierung 30 unter Verwendung einer Schattenmaske, die ebenfalls mittels des LIDE-Verfahren gefertigt wurde, auf die Kammstruktur 25, genauer auf die Seitenwände 13 der Finger 24, aufgebracht. Die schwarzen Bereiche in Figur 15 illustrieren dabei die Öffnung der Schattenmaske und damit die Bereiche des Glas-Substrats 3, die metallisiert werden.

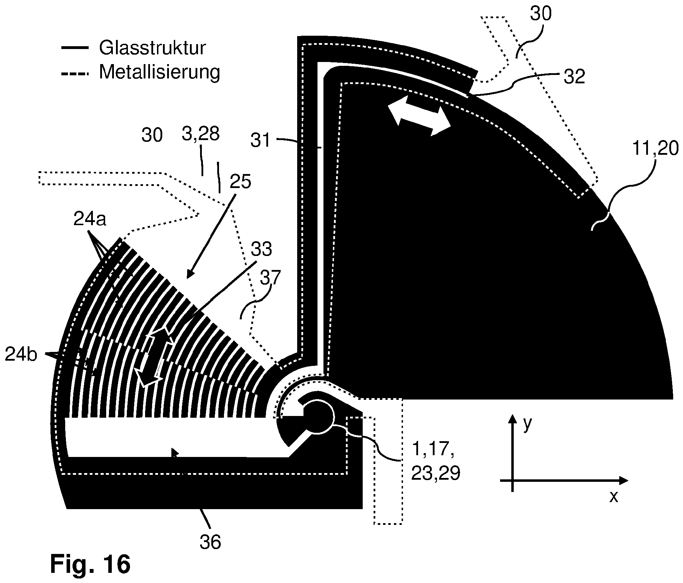

Die hieraus resultierende Kammstruktur 25 der Figur 16, die einen elektrostatischen Rotationsantrieb / Aktuator 33 realisiert, umfasst einen statischen Anker 37 der eine Vielzahl an statischen ersten Fingern 24a ausbildet, sowie einen zweiten beweglich gelagerten Anker 36 der eine Vielzahl an beweglichen zweiten Fingern 24b ausbildet. Die beweglichen zweiten Finger 24b sind dabei in jeweiligen Zwischenräumen der statischen ersten Finger 24a angeordnet. Die Finger 24a, 24b bilden somit eine Interdigitalstruktur. Die beweglichen Finger 24b sind / der Anker 36 ist dabei über ein mikromechanisches Federelement 29 (das im Detail in Figur 7 illustriert ist) am Glas-Substrat 3 aufgehängt. Das Federelement 29 bildet eine Spiralfeder, die eine Rotation der Finger 24b/des Ankers 36 um einen Rotationspunkt erlaubt, der im Zentrum der Spirale liegt. Dadurch kann ein Arm 31, der ein Endstück 32 trägt, mit Hilfe des elektrostatischen Aktuators 33 rotiert werden. Hierzu ist der Arm 31 mit dem Anker 36 drehfest verbunden (der Arm 31 und der Anker 36 sind monolithisch ausgebildet). Das Endstück 32 könnte zum Beispiel als optischer Spiegel ausgestaltet werden, um Licht abzulenken, oder beispielsweise als elektromechanischer Schalter. Die in Figur 16 gezeigte Kammstruktur 25 könnte aber beispielsweise auch als Teil eines Drucksensors verwendet werden, etwa wenn die Bewegung des Arms 31 in unterschiedlichen Luftdrücken mehr oder weniger stark gedämpft würde, was sich dann sensorisch auswerten lässt.

Es versteht sich, dass eine wie in Figur 16 gezeigte mikromechanische Kammstruktur 25 selbstverständlich auch als elektrostatischer Sensor verwendet werden kann, etwa um eine Rotationsbewegung des Arms 31 elektrisch zu erfassen und zu vermessen. Denn bei Bewegung des Arms und der daraus resultierenden Bewegung der Finger 24b ändert sich die Kapazität der Interdigitalstruktur des Kammstruktur 25, was elektrisch ausgewertet werden kann. Zudem lassen sich auch elektrostatische Linear-Antriebe oder Schritt-Aktuatoren mit einer erfindungsgemäßen Kammstruktur 25 realisieren.

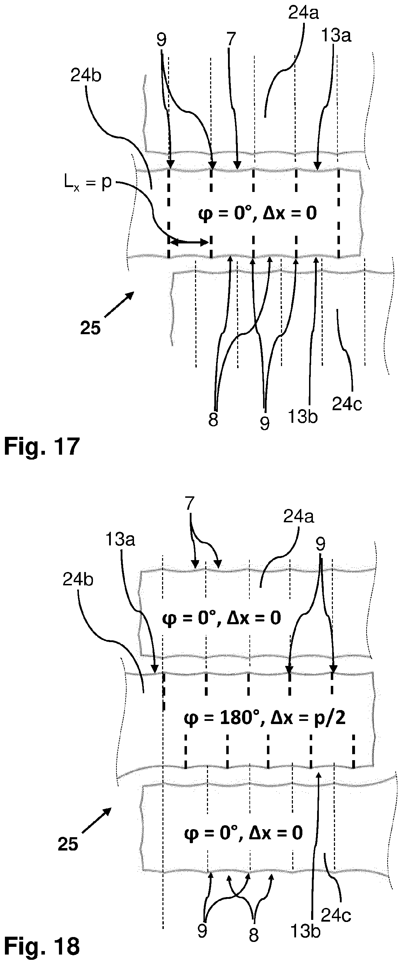

Die Figuren 17 und 18 illustrieren, wie das sidewall scalloping, also die Einbuchtungen 8 in den Seitenwänden 13 der Finger 24, gezielt eingestellt werden kann, um eine möglichst gleichmäßige Aktuierung zu ermöglichen. In beiden Fällen ist die jeweilige räumliche Phasenlage ϕ(x) der sich gegenüberliegenden Rippen 9 in Seitenwänden 13a, 13b des mittleren beweglichen Fingers 24b der Kammstruktur 25 so gewählt, dass in der gezeigten momentanen Aktuierungsstellung diejenigen Rippen 9, die in Seitenwänden 13a, 13b des mittleren Fingers 24b ausgebildet sind, auf der (in der Zeichnung) oberen Seite fluchtend mit entsprechenden Rippen 9 des ersten direkt benachbarten statischen Fingers 24a und auf der gegenüberliegenden unteren Seite versetzt zu entsprechenden Rippen 9 des zweiten direkt benachbarten statischen Fingers 24c ausgebildet sind. Wenn sich der jeweilige mittlere Finger 24 b um eine halbe Länge Lₓ/2 zwischen zwei Rippen 9 nach rechts bewegt hat, dreht sich die Situation gerade um, denn dann besteht der Versatz zu den Rippen des Fingers 24a, während die untere Rippen 9 zu den Rippen 9 des Fingers 24c ausgerichtet sind.

Wird hingegen eine schrittweise Aktuierung angestrebt, so können in einer bestimmten Aktuierungsstellung die Rippen des jeweiligen Fingers beidseitig jeweils zu Rippen eines jeweiligen direkt benachbarten Fingers fluchten. Zudem kann dann ein besonders ausgeprägtes sidewall scalloping vorteilhaft sein, um die gewünschte nicht-lineare Aktuierung zu ermöglichen.

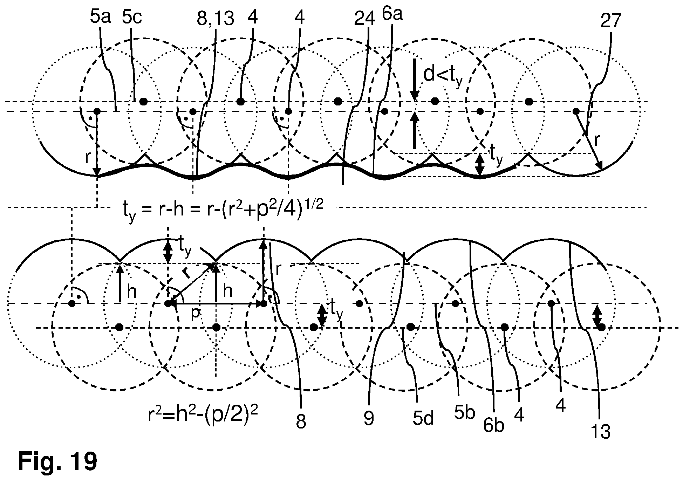

Zur Verdeutlichung der Erfindung sei abschließend noch auf die Figur 19 hingewiesen, die in der oberen Hälfte eine von den bisherigen erfindungsgemäßen Beispielen abweichende Ausgestaltung eines Fingers 24 einer Kammstruktur 25 zeigt: Wie zu sehen ist, wird die obere Kontur 6a, die annähernd dem fett hervorgehobenen wellenförmigen Verlauf folgt, durch Laserpulse 4 von zwei Werkzeugbahnen 5a und 5c definiert, wobei nur die Laserpulse 4 der Werkzeugbahn 5a einen Maximalabstand von r (= Ätzradius 27) von den konkaven Einbuchtungen 8 in der Seitenwand 13 des Fingers 24 zeigen, während der Abstand zwischen den Einbuchtungen 8 und den Laserpulsen 4 der Werkzeugbahn 5c etwas größer als der Ätzradius 27 ist. Die untere Kontur 6b zeigt hingegen den Grenzfall: Die Laserpulse 4 auf der untersten Werkzeugbahn 5d dienen dem Freilegen des Zwischenraums zwischen den Fingern 24, sie definieren jedoch nicht die Kontur 6b, da sie in einem Mindestabstand von t_{y} = r-(r²+p²/4)^{1/2} (= laterale Tiefe der Einbuchtungen 8, die sich geometrisch aus dem Pulsabstand p und dem Ätzradius r ergibt) zur Werkzeugbahn 5b gesetzt wurden. Somit wird die untere Kontur 6b, wie es die Erfindung vorschlägt, ausschließlich durch die Laserpulse 4 der Werkzeugbahn 5b definiert, die jeweils im Abstand r zu den konkaven Einbuchtungen 8 der unteren Kontur 6b gesetzt wurden. Alle Laserpulse 4, die die untere Kontur 6b in dem gezeigten Abschnitt bestimmen, liegen somit auf einer einzigen kontinuierlichen Werkzeugbahn 5b. Entsprechend zeigt auch nur die untere Kontur 6b ein charakteristisches sidewall scalloping mit konvexen (und spitz zulaufenden) Rippen 9 zwischen den Einbuchtungen 8.

Nachfolgend werden einige beispielshafte Design- und Prozessparameter von erfindungsgemäß ausgestalteten Fingern 24 einer Kammstruktur 25 tabellarisch für unterschiedliche Substratdicken und Substratmaterialien aufgelistet, und zwar:

### A) Beispiele für erfindungsgemäße Finger mit geringem Sidewall Scalloping

**Tab. 1: Substratmaterial: Mempax / BF33**

| **Substratdicke [µm]** | **500** | **400** | **300** | **200** | **100** |
|---|---|---|---|---|---|
| Ätzdurchmesser (*D*=*2r*) [µm] | 25 | 20 | 20 | 15 | 15 |
| Pulsabstand (*p*) [µm] | 3 | 3 | 3 | 3 | 3 |
| Fingerbreite (*B*) [µm] | 10 | 10 | 10 | 10 | 10 |
| Scalloping Tiefe (*t*_{y}) [µm] | 0,09 | 0,11 | 0,11 | 0,15 | 0,15 |
| Taper (*φ*) [°] | 1,5 | 1,5 | 1,5 | 1,5 | 1,5 |
| p/r | 0,24 | 0,3 | 0,3 | 0,4 | 0,40 |
| ty/r | 0,0072 | 0,0113 | 0,0113 | 0,0202 | 0,02 |
| ty/B | 0,0090 | 0,0113 | 0,0113 | 0,0152 | 0,02 |
| p/B | 0,3 | 0,3 | 0,3 | 0,3 | 0,3 |

**Tab. 2: Substratmaterial: AF32 (= Glassubstrat mit niedrigem thermischen Ausdehnungskoeffizienten, der dem eines Siliziumwafers ähnelt)**

| **Substratdicke [µm]** | **500** | **400** | **300** | **200** | **100** |
|---|---|---|---|---|---|
| Ätzdurchmesser (*D*=*2r*) [µm] | 65 | 55 | 40 | 30 | 20 |
| Pulsabstand (*p*) [µm] | 5 | 5 | 5 | 5 | 5 |
| Fingerbreite (*B*) [µm] | 10 | 10 | 10 | 10 | 10 |
| Scalloping Tiefe (*t*_{y}) [µm] | 0,1 | 0,11 | 0,16 | 0,21 | 0,32 |
| Taper (*φ*) [°] | 6 | 6 | 6 | 6 | 6 |
| p/r | 0,15385 | 0,1818 | 0,25 | 0,333 | 0,50 |
| ty/r | 0,00296 | 0,0041 | 0,0078 | 0,0140 | 0,03 |
| ty/B | 0,00963 | 0,0114 | 0,0156 | 0,0210 | 0,03 |
| p/B | 0,5 | 0,5 | 0,5 | 0,5 | 0,5 |

**Tab. 3: Substratmaterial: Fused Silica**

| **Substratdicke [µm]** | **500** |
|---|---|
| Ätzdurchmesser (*D=2r*) [µm] | 20 |
| Pulsabstand (*p*) [µm] | 5 |
| Fingerbreite (*B*) [µm] | 10 |
| Scalloping Tiefe (*t*_{y}) [µm] | 0,32 |
| Taper (*φ*) [°] | 0,5 |
| p/r | 0,5 |
| ty/r | 0,03 |
| ty/B | 0,03 |
| p/B | 0,5 |

**B) Beispiele für erfindungsgemäße Finger mit ausgeprägtem Sidewall Scalloping**

**Tab. 4: Substratmaterial: Mempax / BF33**

| **Substratdicke [µm]** | **500** | **400** | **300** | **200** | **100** |
|---|---|---|---|---|---|
| Ätzdurchmesser (*D=2r*) [µm] | 25 | 20 | 20 | 15 | 15 |
| Pulsabstand (*p*) [µm] | 10 | 10 | 10 | 10 | 10 |
| Fingerbreite (*B*) [µm] | 10 | 10 | 10 | 10 | 10 |
| Scalloping Tiefe (*t*_{y}) [µm] | 1,04 | 1,34 | 1,34 | 1,91 | 1,91 |
| Taper (*φ*) [°] | 1,5 | 1,5 | 1,5 | 1,5 | 1,5 |
| p/r | 0,80 | 1,00 | 1,00 | 1,33 | 1,33 |
| ty/r | 0,08 | 0,13 | 0,13 | 0,25 | 0,25 |
| ty/B | 0,10 | 0,13 | 0,13 | 0,19 | 0,19 |
| p/B | 1 | 1 | 1 | 1 | 1 |

**Tab. 5: Substratmaterial: AF32 (= Glassubstrat mit niedrigem thermischen Ausdehnungskoeffizienten, der dem eines Siliziumwafers ähnelt)**

| **Substratdicke [µm]** | **500** | **400** | **300** | **200** | **100** |
|---|---|---|---|---|---|
| Ätzdurchmesser (*D=2r*) [µm] | 65 | 55 | 40 | 30 | 20 |
| Pulsabstand (*p*) [µm] | 15 | 15 | 15 | 15 | 15 |
| Fingerbreite (*B*) [µm] | 10 | 10 | 10 | 10 | 10 |
| Scalloping Tiefe (*t*_{y}) [µm] | 0,88 | 1,04 | 1,46 | 2,01 | 3,39 |
| Taper (*φ*) [°] | 6 | 6 | 6 | 6 | 6 |
| p/r | 0,46 | 0,55 | 0,75 | 1,00 | 1,50 |
| ty/r | 0,03 | 0,04 | 0,07 | 0,13 | 0,34 |
| ty/B | 0,09 | 0,10 | 0,15 | 0,20 | 0,34 |
| p/B | 1,5 | 1,5 | 1,5 | 1,5 | 1,5 |

**Tab. 6: Substratmaterial: Fused Silica**

| **Substratdicke [µm]** | **500** |
|---|---|
| Ätzdurchmesser (*D=2r*) [µm] | 20 |
| Pulsabstand (*p*) [µm] | 5 |
| Fingerbreite (*B*) [µm] | 10 |
| Scalloping Tiefe (*t*_{y}) [µm] | 0,32 |
| Taper (*φ*) [°] | 0,5 |
| p/r | 0,5 |
| ty/r | 0,03 |
| ty/B | 0,03 |
| p/B | 0,5 |

Wie anhand der Zahlenwerte erkennbar ist, bewegen sich bei diesen Beispielen die Ätzdurchmesser D=2r im Bereich weniger pm, typischerweise kann gelten: r ≤ 50 µm oder sogar r ≤ 20 µm oder sogar r ≤ 10 µm. Hierbei gilt für das Verhältnis aus Ätzdurchmesser D=2r und Substratdicke t typischerweise mindestens: D/t ≤ 1:5 = 0,2; bei sehr großer Substratdicke (t≥ 400 pm) kann sogar gelten D/t ≤ 1:20 = 0,05. Der angegebene Taperwinkel *φ* 22 beschreibt dabei die Neigung der Seitenwandflächen 13 der Finger 24 zur z-Achse (= Flächennormale 26 des Substrats 3) - vergleiche dazu die Figuren 11-13.

Bei dem Beispiel der Tabelle 6 wird ein Aspektverhältnis (= Substratdicke:Federbreite) des Fingers 24 von 100 erzielt. Das sidewall scalloping ist dabei immer noch sehr schwach ausgeprägt mit einem Verhältnis t_{y}/r = 0,03. Dies zeigt, dass sich mittels LIDE sehr homogene Finger 24 mit enormem Aspektverhältnis fertigen lassen, die sich vortrefflich für mikromechanische Kammstrukturen 25 eignen. Bei den Beispielen der Tabelle 4 nimmt das Ausmaß des sidewall scalloping mit abnehmender Substratdicke zu. Bei einer Substratdicke von 100 um gilt etwa t_{y}/B = 19% und t_{y}/r > 20%. Bei gleicher Substratdicke von 100 um beträgt in Tabelle 5 das Verhältnis aus lateraler Tiefe t_{y} der Einbuchtung 8 und maximaler Breite B 15 des Fingers 24 sogar 34%. Entsprechend sind bei diesen Beispielen deutliche Einbuchtungen 8 bzw. Rippen 9 in den Seitenwänden 13 der Mikrostruktur 1 ausgebildet. Derartige Finger 24 wären geeignet zur Verwendung in einem Schritt-Aktuator.

Zusammenfassend wird zur Ausweitung der Anwendungsmöglichkeiten des vorbekannten LIDE (laser induced deep etching) Verfahrens vorgeschlagen, bei der Herstellung einer mikromechanischen Kammstruktur 25 durch Setzen von einer Vielzahl von Laserpulsen 4 auf einem Glas-Substrat 3 mit nachfolgendem nasschemischen Ätzschritt zum Freilegen der Kammstruktur 25 die Lage der Laserpulse 4 genau zu kontrollieren, die die äußere Kontur 6 von jeweiligen Fingern 24 der Kammstruktur 25 definieren. Dadurch wird es möglich, sehr schmale Finger 24 auszubilden, die gleichmäßig ausgebildete Seitenwände 13 aufweise, sodass sehr geringe Spaltmaße 35 und eine gleichmäßige elektrostatische Aktuierung der Kammstruktur 25 ermöglicht wird. Durch Kontrolle der Phasenlage ϕ und/oder des Ausmaßes des sidewall scalloping der Finger 24 ist es zudem möglich, die mechanischen Eigenschaften günstig zu beeinflussen bzw. gezielt einzustellen (Vgl. Figur 9) .

### Bezugszeichenliste

- 1: Mikrostruktur, insbesondere Biegestruktur
- 2: Verlaufsrichtung (von 1)
- 3: Glas-Substrat
- 4: Laserpuls (der Auftreffpunkt auf 3 definiert einen Laserpunkt mit xy-Koordinaten auf der Oberfläche von 3)
- 5: Werkzeugbahn (entlang derer der Laserkopf geführt und auf welcher die Laserpulse gesetzt werden)
- 6: Kontur (von 1, insbesondere äußere Begrenzung von 1 in der Substratoberfläche / an der Oberseite von 1)
- 7: Ätzprofil (in der xy-Ebene, verursacht durch 4)
- 8: (konkave) Einbuchtung (in Seitenwand von 24)
- 9: (konvexe) Rippe (in Seitenwand von 24)
- 10: Werkzeugbahnenabstand (bzw. lokaler y-Abstand zwischen 4)
- 11: modifizierte Bereiche (in 3)
- 12: Auslenkungsbereich (von 1)
- 13: Seitenwand, bzw. Seitenwandfläche (von 1)
- 14: laterale Tiefe (von 14)
- 15: (maximale) Breite (von 1 quer zu 2)
- 16: Federbalken
- 17: Festkörpergelenk
- 18: Laserpulspaar
- 19: Mittelachse beziehungsweise Mittellinie (von 1)
- 20: (nasschemisch) freigeätzter Bereich
- 21: Mittelebene (von 3)
- 22: Taperwinkel *φ*
- 23: Biegestruktur (beispielsweise ausgestaltet als mikromechanisches Federelement)
- 24: beweglicher Finger (von 25)
- 25: mikromechanische Kammstruktur
- 26: Flächennormale (von 3 = z-Achse)
- 27: Ätzradius
- 28: Substrat-Ebene (von 3 = xy-Ebene)
- 29: Mikromechanisches Federelement
- 30: Metallisierung (insbesondere von 13)
- 31: bewegter Arm
- 32: Endstück (von 31 aktuiert durch 25)
- 33: Elektrostatische Aktuierung / elektrostatischer Aktuator
- 34: Innenwinkel (von 13)
- 35: Spaltmaß
- 36: beweglicher Anker
- 37: statischer Anker

## Patentansprüche

1. **Mikromechanische Kammstruktur (25) aus Glas** mit
- einer Vielzahl an mikromechanischen Fingern (24), wobei die Kammstruktur (25) in einer durch ein Glas-Substrat (3) definierten Substrat-Ebene (28) auslenkbar ist, und
- wobei die Finger (24) aus dem Glas-Substrat (3) durch laserinduzierte Modifikation des Glas-Substrats (3) und nachfolgende nasschemische anisotrope Ätzung freigelegt wurden,
- wobei bei der Herstellung der Finger (24) Laserpulse (4), die eine äußere Kontur (6) der Finger (24) definieren, auf jeweiligen kontinuierlichen, insbesondere geradlinigen oder kurvenförmigen, sich gegenüberliegenden Werkzeugbahnen (5a, 5b) gesetzt wurden, vorzugsweise in einem konstanten Pulsabstand p,
- wobei jede der Werkzeugbahnen (5a, 5b) einen Maximalabstand r zu der Kontur (6) aufweist, der gerade einem Ätzradius (27) r eines nasschemischen Ätzschritts entspricht, der zum Freilegen der Finger (24) eingesetzt wurde und
- wobei die Finger (24) Seitenwandelektroden aufweisen, um eine elektrostatische Aktuierung oder eine kapazitive Sensorik mit Hilfe der Kammstruktur (25) zu realisieren.

2. Mikromechanische Kammstruktur (25) aus Glas gemäß Anspruch 1, wobei wenigstens ein Festkörpergelenk (17), über das die Kammstruktur (25) mit dem Glas-Substrat (3) monolithisch verbunden ist, um die Auslenkbarkeit zu ermöglichen, durch die laserinduzierte Modifikation des Glas-Substrats (3) und die nachfolgende nasschemische anisotrope Ätzung freigelegt wurde.

3. Mikromechanische Kammstruktur (25) aus Glas gemäß Anspruch 1 oder 2, wobei die Finger (24) jeweils zwei sich gegenüberliegende Seitenwände (13a, 13b) aufweisen, die konkave Einbuchtungen (8) zeigen,
- die jeweils eine Krümmung mit einem Ätzradius r zeigen und die durch jeweilige konvexe Rippen (9) begrenzt sind,
- vorzugsweise wobei die Einbuchtungen (8), zumindest abschnittsweise vorzugsweise jedoch entlang einer gesamten Länge des jeweiligen Fingers (24), einen konstanten mittleren Abstand Lₓ zeigen,
- insbesondere wobei die Rippen (9) einer äußeren gedachten Konturbahn (36) folgen, die parallel verläuft zu einer Mittelachse (19) oder Mittellinie (19) des jeweiligen Fingers (24),
- insbesondere sodass eine Welligkeit der Konturbahn (36) minimiert ist.

4. Mikromechanische Kammstruktur (25) aus Glas gemäß einem der vorhergehenden Ansprüche, wobei sich gegenüberliegende Rippen (9), die in sich gegenüberliegenden Seitenwänden (13a, 13b / 13c, 13) eines jeweiligen der Finger (24) ausgebildet sind, einen Versatz Δx entlang einer Verlaufsrichtung (2) des Fingers (24) zeigen, für den gilt: Lₓ/4 ≤ Δx ≤ Lₓ/2, mit Lₓ dem mittleren Abstand zwischen zwei direkt benachbarten der Rippen (9), die in derselben Seitenwand (13a/13b) ausgebildet sind.

5. Mikromechanische Kammstruktur (25) aus Glas gemäß einem der vorhergehenden Ansprüche, wobei zur Erzielung eines schwach ausgeprägten sidewall scalloping die Laserpulse (4) so gesetzt wurden und die Finger (24) so freigeätzt wurden, dass für ein Verhältnis aus einem mittleren Pulsabstand p zwischen benachbarten Laserpulsen (4) auf einer der beiden Werkzeugbahnen (5a oder 5b) und dem Ätzradius (27) r, vorzugsweise entlang der gesamten Länge des jeweiligen Fingers (24), gilt: p < r, vorzugsweise p < r/2, besonders bevorzugt p < r/3.

6. Mikromechanische Kammstruktur (25) aus Glas gemäß einem der vorhergehenden Ansprüche, wobei eine jeweilige räumliche Phasenlage ϕ(x) von jeweiligen Laserpulspaaren (18) bzw. sich gegenüberliegenden Rippen (9) in Seitenwänden (13a, 13b) eines der Finger (24b) entlang einer jeweiligen Verlaufsrichtung (2) des Fingers (24b) so gewählt ist,
- dass in einer bestimmten Aktuierungsstellung der Kammstruktur (25) Rippen (9), die in Seitenwänden (13a, 13b) des Fingers (24b) ausgebildet sind,
- auf einer Seite fluchtend mit entsprechenden Rippen (9) eines ersten direkt benachbarten Fingers (24a) und
- auf einer gegenüberliegenden Seite versetzt zu entsprechenden Rippen (9) eines zweiten direkt benachbarten Fingers (24c) ausgebildet sind,
- insbesondere wobei sich gegenüberliegende Rippen (9) des Fingers (24b), der zwischen dem ersten und zweiten direkt benachbarten Finger (24a, 24c) liegt, ein Versatz Δx < Lₓ/4 zeigen, insbesondere von Δx = 0.

7. **Mikromechanischer Aktuator** umfassend eine Kammstruktur (25) gemäß einem der vorhergehenden Ansprüche, wobei die Seitenwandelektroden zur elektrostatischen Aktuierung der Kammstruktur (25) vorgesehen sind.

8. **Mikromechanischer Schritt-Aktuator** basierend auf einer Kammstruktur (25) aus Glas gemäß einem der Ansprüche 1 bis 6 mit einer Vielzahl an Fingern (24), die aus einem Glas-Substrat (3) durch laserinduzierte Modifikation des Glas-Substrats (3) und nachfolgende nasschemische anisotrope Ätzung freigelegt wurden,
- wobei eine Schrittgröße G des Schritt-Aktuators einem Abstand Lₓ von konvexen Rippen (9) entspricht (Lₓ = G), welche seitliche konkave Einbuchtungen (8) begrenzen, die in Seitenwänden (13) der Finger (24) ausgebildet sind und eine Krümmung mit einem Ätzradius (27) *r* zeigen,
- vorzugsweise wobei für ein Verhältnis aus dem Ätzradius (27) *r* und einer lateralen Tiefe *t_{y}* (14) der jeweiligen Einbuchtungen (8) gilt: t_{y}/r >0.1, vorzugsweise t_{y}/r > 0.2 und/oder
- wobei für ein Verhältnis aus dem Abstand Lₓ = G und dem Ätzradius r gilt: Lₓ /r > 0,5, bevorzugt Lₓ /r > 0,7.

9. **Verfahren zur Herstellung einer mikromechanischen Kammstruktur (25) aus Glas**, insbesondere gemäß einem der Ansprüche 1 bis 6,
- wobei die Kammstruktur (25) eine Vielzahl an mikromechanischen Fingern (24) umfasst und in einer durch ein Glas-Substrat (3) definierten Substrat-Ebene (28) auslenkbar ist und
- wobei die Finger (24) aus dem Glas-Substrat (3) durch laserinduzierte Modifikation des Glas-Substrats (3) und nachfolgende nasschemische anisotrope Ätzung freigelegt werden,
- wobei zum Freilegen der Finger (24) Laserpulse (4), die eine äußere Kontur (6) der Finger (24) definieren sollen, auf jeweiligen kontinuierlichen, insbesondere geradlinigen oder kurvenförmigen, sich gegenüberliegenden Werkzeugbahnen (5a, 5b) gesetzt werden, vorzugsweise in einem konstanten Pulsabstand p,
- wobei anschließend alle Finger (24) der Kammstruktur (25) in einem gemeinsamen nasschemischen Ätzschritt freigelegt werden, sodass eine jeweilige äußere Kontur (6) der Finger (24) einen Maximalabstand r zu der zugehörigen Werkzeugbahn (5a, 5b) aufweist, der einem Ätzradius (27) r des Ätzschritts entspricht und
- wobei Seitenwandelektroden an den Fingern (24) ausgebildet werden, um eine elektrostatische Aktuierung oder eine kapazitive Sensorik mit Hilfe der Kammstruktur (25) zu realisieren.

10. Verfahren gemäß dem vorgehenden Anspruch,
- wobei eine Anisotropie des Ätzschritts so gewählt ist, dass die Finger (24) mit einem Taperwinkel *φ* (22) von höchstens 6°, vorzugsweise von höchstens 3°, in Bezug auf eine Flächennormale (26) der Substrat-Ebene (28) ausgebildet werden,
- vorzugsweise wobei ein Verhältnis aus einer ersten Ätzrate von mittels Laserstrahlung modifizierten Bereichen (11) des Glas-Substrats (3) und einer zweiten Ätzrate von nicht modifizierten Bereichen des Glas-Substrats (3) größer 15:1 gewählt ist.

11. Verfahren nach einem der beiden vorhergehenden Ansprüche, wobei die Finger (24) mit einer rautenförmigen Querschnittsform freigestellt werden, indem von zwei Seiten des Glas-Substrats (3) her mit einer nasschemischen Ätzlösung geätzt wird, und
- wobei die Anisotropie des Ätzschritts so eingestellt ist, dass die Finger (24) nach dem Ätzen einen Innenwinkel (34) in Bezug auf eine jeweilige Seitenwand (13) von wenigstens 170° ausbilden,
- vorzugsweise wobei jeweils dieselbe nasschemische Ätzlösung, vorzugsweise und näherungsweise gleiche Prozessparameter wie etwa Konzentration und/oder Temperatur der Ätzlösung, verwendet wird/werden, um beide Seiten des Glas-Substrats (3) zu ätzen,
- besonders bevorzugt wobei die beidseitige Ätzung in einem einzigen Ätzschritt vorgenommen wird.

12. Verfahren nach einem der Ansprüche 9 bis 11,
- wobei zur Erzielung eines schwach ausgeprägten sidewall scalloping die Laserpulse (4) so gesetzt werden und die Finger (24) so freigeätzt werden, dass für ein Verhältnis aus einem mittleren Pulsabstand p zwischen benachbart platzierten Laserpulsen (4) und einem Ätzradius r, vorzugsweise entlang einer gesamten Länge des jeweiligen Fingers (24), gilt: p < r, vorzugsweise p < r/2.

13. Verfahren nach einem der Ansprüche 9 bis 12,
- wobei eine jeweilige Kontur (6) der Finger (24) seitliche konkave Einbuchtungen (8) zeigt, die jeweils eine Krümmung mit einem Ätzradius r an einer Oberfläche des Glas-Substrats (3) zeigen und die durch jeweilige konvexe Rippen (9) begrenzt sind, und
- wobei für das Verhältnis aus dem lokalen Ätzradius (27) r und einer lateralen Tiefe *t_{y}* (14) der jeweiligen Einbuchtungen (8) gilt: t_{y}/r < 0.1, vorzugsweise t_{y}/r < 0.05.
- vorzugsweise wobei zusätzlich oder ergänzend für das Verhältnis aus maximaler Breite B (15) des jeweiligen Fingers (24) quer zu seiner Verlaufsrichtung (2) und der lateralen Tiefe t_{y} (14) gilt: t_{y}/B ≤ 0,1, insbesondere t_{y}/B ≤ 0,05.

14. Verfahren nach einem der Ansprüche 9 bis 13,
- wobei eine Metallisierung (30), die der Ausbildung von Elektroden der Finger (24) dient, unter Verwendung
- einer Schattenmaske oder
- eines Sprüh-Photolacks oder
- eines laminierbaren Trocken-Photolacks als Maskierungsschicht auf Seitenwände (13) der Finger (24) aufgebracht wird,
- vorzugsweise mittels physical vapor deposition (PVD), insbesondere mittels Sputtern.

15. **Verwendung einer mikromechanischen Kammstruktur (25) aus Glas, in einem portablen elektronischen Gerät,**
- wobei die Kammstruktur (25) gemäß einem der Ansprüche 1 bis 6 ausgebildet ist und/oder gemäß einem der Ansprüche 9 bis 14 hergestellt ist und
- wobei die Kammstruktur (25) als Teil eines elektrostatischen Aktuators (33) und/oder als Teil eines kapazitiven Sensors dazu eingesetzt wird, eine elektrostatische Haltekraft energiesparsam auszuüben bzw. aufrechtzuerhalten,
- insbesondere wobei die Finger (24) der Kammstruktur (25) eine jeweilige Länge von > 100 um, insbesondere von > 300 um, aufweisen.

## Claims

1. **Micromechanical comb structure (25) made of glass**, comprising
- a plurality of micromechanical fingers (24), wherein the comb structure (25) is deflectable in a substrate plane (28) defined by a glass substrate (3), and
- wherein the fingers (24) have been exposed from the glass substrate (3) by laser-induced modification of the glass substrate (3) and subsequent wet-chemical anisotropic etching,
- wherein during the production of the fingers (24) laser pulses (4), which define an outer contour (6) of the fingers (24), were placed on respective continuous, in particular rectilinear or curved, opposing tool paths (5a, 5b), preferably at a constant pulse spacing p,
- wherein each of the tool paths (5a, 5b) has a maximum distance r from the contour (6) which just corresponds to an etching radius (27) r of a wet-chemical etching step which was used to expose the fingers (24), and
- wherein the fingers (24) have sidewall electrodes to realize electrostatic actuation or capacitive sensing by means of the comb structure (25).

2. Micromechanical comb structure (25) made of glass according to claim 1, wherein at least one solid-state joint (17), via which the comb structure (25) is monolithically connected to the glass substrate (3) in order to enable the deflectability, was exposed by the laser-induced modification of the glass substrate (3) and the subsequent wet-chemical anisotropic etching.

3. Micromechanical comb structure (25) made of glass according to claim 1 or 2, wherein the fingers (24) each have two opposing side walls (13a, 13b) which show concave indentations (8),
- which each exhibit a curvature with an etching radius r and which are delimited by respective convex ribs (9),
- preferably wherein the indentations (8), at least in sections but preferably along an entire length of the respective finger (24), exhibit a constant mean distance Lₓ,
- in particular wherein the ribs (9) follow an outer imaginary contour path (36) which extends parallel to a central axis (19) or centerline (19) of the respective finger (24),
- in particular so that a waviness of the contour path (36) is minimized.

4. Micromechanical comb structure (25) made of glass according to one of the preceding claims, wherein opposite ribs (9), which are formed in opposite side walls (13a, 13b/13c, 13) of a respective one of the fingers (24), show an offset Δx along a running direction (2) of the finger (24), for which the following applies: Lₓ/4 ≤ Δx ≤ Lₓ/2, with Lₓ the mean distance between two directly adjacent ones of the ribs (9) formed in the same side wall (13a/13b).

5. Micromechanical comb structure (25) made of glass according to one of the preceding claims, wherein to achieve a weakly pronounced sidewall scalloping the laser pulses (4) were set and the fingers (24) were free-etched in such a way that for a ratio of an average pulse spacing p between adjacent laser pulses (4) on one of the two tool paths (5a or 5b) and the etching radius (27) r, preferably along the entire length of the respective finger (24), the following applies: p < r, preferably p < r/2, particularly preferably p < r/3.

6. Micromechanical comb structure (25) made of glass according to one of the preceding claims, wherein a respective spatial phase position ϕ (x) of respective laser pulse pairs (18) or opposing ribs (9) in side walls (13a, 13b) of one of the fingers (24b) along a respective running direction (2) of the finger (24b) is selected such that
- in a specific actuation position of the comb structure (25), ribs (9), which are formed in side walls (13a, 13b) of the finger (24b), are formed
- on one side aligned with corresponding ribs (9) of a first directly adjacent finger (24a) and
- on an opposite side offset from corresponding ribs (9) of a second directly adjacent finger (24c),
- in particular wherein opposite ribs (9) of the finger (24b) located between the first and second directly adjacent fingers (24a, 24c) exhibit an offset Δx < Lₓ/4, in particular of Δx = 0.

7. **Micromechanical actuator** comprising a comb structure (25) according to one of the preceding claims, wherein the sidewall electrodes are provided for electrostatically actuating the comb structure (25).

8. **Micromechanical step actuator** based on a comb structure (25) of glass according to one of claims 1 to 6, comprising a plurality of fingers (24) exposed from a glass substrate (3) by laser-induced modification of the glass substrate (3) and subsequent wet-chemical anisotropic etching,
- wherein a step size G of the step actuator corresponds to a distance Lₓ of convex ribs (9) (Lₓ = G) delimiting lateral concave indentations (8) which are formed in side walls (13) of the fingers (24) and show a curvature with an etching radius (27) r,
- preferably wherein the following applies for a ratio of the etching radius (27) *r* and a lateral depth *t_{y}* (14) of the respective indentations (8): t_{y}/r >0.1, preferably t_{y}/r >0.2 and/or
- wherein the following applies for a ratio of the etching distance Lₓ = G and the etching radius r: Lₓ/r > 0.5, preferably Lₓ/r > 0.7.

9. **Method for producing a micromechanical comb structure (25) made of glass,** in particular according to one of claims 1 to 6,
- wherein the comb structure (25) comprises a plurality of micromechanical fingers (24) and can be deflected in a substrate plane (28) defined by a glass substrate (3), and
- wherein the fingers (24) are exposed from the glass substrate (3) by laser-induced modification of the glass substrate (3) and subsequent wet-chemical anisotropic etching,
- wherein, for exposing the fingers (24), laser pulses (4), which are intended to define an outer contour (6) of the fingers (24), are applied to respective continuous, in particular rectilinear or curved, opposing tool paths (5a, 5b), preferably at a constant pulse spacing p,
- wherein all fingers (24) of the comb structure (25) are subsequently exposed in a common wet-chemical etching step, so that a respective outer contour (6) of the fingers (24) has a maximum distance r from the associated tool path (5a, 5b), which corresponds to an etching radius (27) r of the etching step, and
- wherein sidewall electrodes are formed on the fingers (24) in order to realize electrostatic actuation or capacitive sensor technology with the aid of the comb structure (25).

10. Method according to the preceding claim,
- wherein an anisotropy of the etching step is selected such that the fingers (24) are formed with a taper angle *Φ* (22) of at most 6°, preferably of at most 3°, with respect to a surface normal (26) of the substrate plane (28),
- preferably wherein a ratio of a first etching rate of areas modified by laser radiation (11) of the glass substrate (3) and a second etching rate of unmodified areas of the glass substrate (3) is selected to be greater than 15:1.

11. Method according to one of the two preceding claims, wherein the fingers (24) are exposed with a rhombic cross-sectional shape by etching from two sides of the glass substrate (3) with a wet-chemical etching solution, and
- wherein the anisotropy of the etching step is adjusted such that the fingers (24) form an internal angle (34) of at least 170° with respect to a respective side wall (13) after etching,
- preferably wherein the same wet-chemical etching solution, preferably and approximately the same process parameters such as concentration and/or temperature of the etching solution, is/are used in each case to etch both sides of the glass substrate (3),
- particularly preferably wherein the etching on both sides is performed in a single etching step.

12. Method according to one of claims 9 to 11,
- wherein, in order to achieve a weakly pronounced sidewall scalloping, the laser pulses (4) are placed and the fingers (24) are exposed in such a way that for a ratio of an average pulse spacing p between adjacent placed laser pulses (4) and an etching radius r, preferably along an entire length of the respective finger (24), the following applies: p < r, preferably p < r/2.

13. Method according to one of claims 9 to 12,
- wherein a respective contour (6) of the fingers (24) shows lateral concave indentations (8), each of which shows a curvature with an etching radius r at a surface of the glass substrate (3) and which are delimited by respective convex ribs (9), and
- wherein the following applies to the ratio of the local etching radius (27) r and a lateral depth t_{y} (14) of the respective indentations (8): t_{y}/r < 0.1, preferably t_{y}/r < 0.05,
- preferably wherein additionally or supplementarily the following applies to the ratio of the maximum width B (15) of the respective finger (24) transverse to its direction of extension (2) and the lateral depth t_{y} (14): t_{y}/B ≤ 0.1, in particular t_{y}/B ≤ 0.05.

14. Method according to one of claims 9 to 13,
- wherein a metallization (30), which serves to form electrodes of the fingers (24), using
- a shadow mask or
- a spray photoresist or
- a laminable dry photoresist is applied to the side walls (13) of the fingers (24) as a masking layer,
- preferably by means of physical vapor deposition (PVD), in particular by means of sputtering.

15. **Use of a micromechanical comb structure (25) made of glass, in a portable electronic device,**
- wherein the comb structure (25) is formed according to one of claims 1 to 6 and/or is manufactured according to one of claims 9 to 14, and
- wherein the comb structure (25) is used as part of an electrostatic actuator (33) and/or as part of a capacitive sensor to exert or maintain an electrostatic holding force in an energy-saving manner,
- in particular wherein the fingers (24) of the comb structure (25) have a respective length of > 100 µm, in particular of > 300 µm.

## Revendications

1. **Structure en peigne (25) micromécanique en verre** avec
- une pluralité de dents (24) micromécaniques, la structure en peigne (25) étant déviable dans un plan de substrat (28) défini par un substrat (3) en verre, et
- les dents (24) ayant été dégagées du substrat (3) en verre par modification induite par laser du substrat (3) en verre et gravure anisotrope chimique par voie humide ultérieure,
- des impulsions laser (4), qui définissent un contour (6) extérieur des dents (24), ayant été placées sur des voies d'outil (5a, 5b) respectives continues, en particulier rectilignes ou curvilignes, opposées, de préférence à un intervalle d'impulsions p constant, lors de la production des dents (24),
- chacune desdites voies d'outil (5a, 5b) présentant une distance maximale r par rapport audit contour (6) qui correspond juste à un rayon de gravure (27) r d'une étape de gravure chimique par voie humide utilisée pour dégager lesdites dents (24) et
- les dents (24) présentant des électrodes de paroi latérale pour réaliser une activation électrostatique ou une détection capacitive à l'aide de la structure en peigne (25).

2. Structure en peigne (25) micromécanique en verre selon la revendication 1, au moins une articulation (17) à l'état solide, par laquelle la structure en peigne (25) est reliée de manière monolithique au substrat (3) en verre pour permettre la capacité de déviation, ayant été dégagée par la modification induite par laser du substrat (3) en verre et la gravure anisotrope chimique par voie humide ultérieure.

3. Structure en peigne (25) micromécanique en verre selon la revendication 1 ou 2, les dents (24) présentant chacune deux parois (13a, 13b) latérales opposées ayant des enfoncements (8) concaves,
- qui ont chacun une courbure avec un rayon de gravure r et qui sont délimitées par des nervures (9) convexes respectives,
- de préférence les enfoncements (8) ayant, au moins par sections mais de préférence sur toute la longueur de la dent (24) respective, une distance moyenne constante Lₓ,
- en particulier les nervures (9) suivant une voie (36) de contour imaginaire extérieure qui s'étend parallèlement à un axe (19) central ou à une ligne (19) médiane de la dent (24) respective,
- en particulier de sorte qu'une ondulation de la voie (36) de contour soit minimisée.

4. Structure en peigne (25) micromécanique en verre selon l'une des revendications précédentes, des nervures (9) opposées formées dans des parois (13a, 13b / 13c, 13) latérales opposées d'une dent respective parmi les dents (24) ayant un décalage Δx le long d'une direction d'allongement (2) de la dent (24) pour laquelle s'applique : Lₓ/4 < Δx < Lₓ/2, avec Lₓ étant la distance moyenne entre deux desdites nervures (9) directement adjacentes formées dans la même paroi (13a/13b) latérale.

5. Structure en peigne (25) micromécanique en verre selon l'une des revendications précédentes, pour obtenir une mise à l'échelle de paroi latérale peu marquée, les impulsions laser (4) ayant été placées et les dents (24) ayant été dégagées par attaque de telle sorte que, pour un rapport entre un intervalle moyen d'impulsions p entre des impulsions laser (4) adjacentes sur l'une des deux voies d'outil (5a ou 5b) et le rayon de gravure (27) r, de préférence sur toute la longueur de la dent (24) respective, s'applique : p < r, de préférence p < r/2, de préférence encore p < r/3.

6. Structure en peigne (25) micromécanique en verre selon l'une des revendications précédentes, une position de phase φ(x) spatiale respective de paires d'impulsions laser (18) respectives ou des nervures (9) opposées dans des parois (13a, 13b) latérales de l'une des dents (24b) le long d'une direction d'extension (2) respective de la dent (24b) étant choisie de telle sorte que
- dans une position d'activation déterminée de la structure en peigne (25), des nervures (9) formées dans des parois (13a, 13b) latérales de la dent (24b) sont formée
- sur un côté, en alignement avec des nervures (9) correspondantes d'une première dent (24a) directement adjacente, et
- sur un côté opposé décalé par rapport à des nervures (9) correspondantes d'une deuxième dent (24c) directement adjacente,
- en particulier des nervures (9) opposées de la dent (24b) situé entre les première et deuxième dents (24a, 24c) directement adjacentes ayant un décalage Δx <Lₓ/4, en particulier de Δx = 0.

7. **Actionneur micromécanique** comprenant une structure en peigne (25) selon l'une des revendications précédentes, les électrodes de paroi latérale étant prévues pour l'activation électrostatique de la structure en peigne (25).

8. **Actionneur micromécanique pas à pas** basé sur une structure en peigne (25) en verre selon l'une des revendications 1 à 6 avec une pluralité de dents (24) ayant été dégagées d'un substrat (3) en verre par modification induite par laser du substrat (3) en verre et gravure anisotrope chimique par voie humide ultérieure,
- une taille de police G de l'actionneur pas à pas correspondant à une distance Lₓ de nervures (9) convexes (Lₓ = G) délimitant des enfoncements (8) concaves latéraux formés dans des parois (13) latérales des dents (24) et ayant une courbure avec un rayon de gravure (27) r,
- de préférence pour un rapport entre le rayon de gravure (27) *r* et une profondeur latérale t_{y} (14) des enfoncements (8) respectifs s'appliquant : t_{y}/r > 0,1, de préférence t_{y}/r > 0,2 et/ou
- pour un rapport entre la distance Lₓ = G et le rayon de gravure r s'appliquant : Lₓ /r > 0,5, de préférence Lₓ /r > 0,7.

9. **Procédé de production d'une structure en peigne (25) micromécanique en verre,** notamment selon l'une des revendications 1 à 6,
- la structure en peigne (25) comprenant une pluralité de dents (24) micromécaniques et étant déviable dans un plan de substrat (28) défini par un substrat (3) en verre et
- les dents (24) étant dégagées du substrat (3) en verre par modification induite par laser du substrat (3) en verre et gravure anisotrope chimique par voie humide ultérieure,
- pour dégager les dents (24), des impulsions laser (4), qui doivent définir un contour (6) extérieur des dents (24), étant placées sur des voies d'outil (5a, 5b) respectives continues, en particulier rectilignes ou curvilignes, opposées, de préférence à un intervalle d'impulsions p constant,
- toutes les dents (24) de la structure en peigne (25) étant ensuite dégagées dans une étape de gravure chimique par voie humide commune de sorte qu'un contour (6) extérieur respectif des dents (24) présente une distance maximale r par rapport à la voie d'outil (5a, 5b) associée, qui correspond à un rayon de gravure (27) r de l'étape de gravure et
- des électrodes de paroi latérale étant formées sur les dents (24) pour réaliser une activation électrostatique ou une détection capacitive à l'aide de la structure en peigne (25).

10. Procédé selon la revendication précédente,
- une anisotropie de l'étape de gravure étant choisie de telle sorte que les dents (24) sont formées avec un angle de transition ø (22) d'au plus 6°, de préférence d'au plus 3°, par rapport à une normale (26) à la surface du plan de substrat (28),
- de préférence un rapport entre un premier taux de gravure de zones (11) de substrat (3) en verre modifiées par rayonnement laser et un deuxième taux de gravure de zones non modifiées du substrat (3) en verre étant choisi supérieur à 15:1.

11. Procédé selon l'une des deux revendications précédentes, les dents (24) avec une forme en losange en coupe transversale étant dégagées en gravant à partir de deux côtés du substrat (3) en verre avec une solution de gravure chimique par voie humide, et
- l'anisotropie de l'étape de gravure étant ajustée de sorte que les dents (24) forment un angle (34) interne par rapport à une paroi (13) latérale respective d'au moins 170° après la gravure,
- de préférence à chaque fois la même solution de gravure chimique par voie humide, de préférence et approximativement les mêmes paramètres de processus tels que la concentration et/ou la température de la solution de gravure étant utilisée/utilisés, pour graver les deux côtés du substrat (3) en verre,
- de préférence encore, la gravure des deux côtés étant effectuée en une seule étape de gravure.

12. Procédé selon l'une des revendications 9 à 11,
- pour obtenir une mise à l'échelle de paroi latérale peu marquée, les impulsions laser (4) étant placées et les dents (24) étant dégagées par attaque de telle sorte que, pour un rapport entre un intervalle moyen d'impulsions p entre des impulsions laser (4) adjacentes et un rayon de gravure r, de préférence sur toute la longueur de la dent (24) respective, s'applique : p < r, de préférence p < r/2.

13. Procédé selon l'une des revendications 9 à 12,
- un contour (6) respectif des dents (24) ayant des enfoncements (8) concaves latéraux qui ont chacun une courbure avec un rayon de gravure r sur une surface du substrat (3) en verre et qui sont délimités par des nervures (9) convexes respectives, et
- le rapport entre le rayon de gravure (27) local *r* et une profondeur latérale *t_{y}* (14) des enfoncements (8) respectifs s'appliquant : t_{y}/r < 0,1, de préférence t_{y}/r < 0,05.
- de préférence, en plus ou en complément, pour le rapport entre la largeur maximale B (15) de la dent (24) respective transversalement à sa direction d'extension (2) et la profondeur latérale t_{y} (14) s'appliquant : t_{y}/B ≤ 0,1, en particulier t_{y}/B ≤ 0,05.

14. Procédé selon l'une des revendications 9 à 13,
- une métallisation (30), qui sert à former des électrodes des dents (24), étant appliquée en utilisant
- un masque d'ombre ou
- une laque photosensible en spray ou
- une laque photosensible à sec laminable
comme couche de masquage sur des parois (13) latérales des dents (24),
- de préférence par dépôt physique en phase vapeur (PVD), notamment par pulvérisation cathodique.

15. **Utilisation d'une structure en peigne (25) micromécanique en verre, dans un appareil électronique portable,**
- la structure en peigne (25) étant formée selon l'une des revendications 1 à 6 et/ou étant produite selon l'une des revendications 9 à 14 et
- la structure en peigne (25) étant utilisée en tant que partie d'un actionneur (33) électrostatique et/ou en tant que partie d'un capteur capacitif pour exercer ou maintenir une force de maintien électrostatique à faible consommation d'énergie,
- en particulier, les dents (24) de la structure en peigne (25) présentant une longueur respective de > 100 µm, en particulier de > 300 µm.
